# EUROPEAN PATENT SPECIFICATION

(11) **EP 0 778 579 B1**
(45) Date of publication and mention of the grant of the patent: **01.10.2003**
(21) Application number: 97101930.2
(22) Date of filing: 29.11.1989
(51) Int. Cl.: G11C 7/00, G09G 1/16

(54) **A synchronous dynamic memory integrated circuit, a method for accessing such a memory, and system comprising such a memory**
Synchrone dynamische integrierte Speicherschaltung, Zugriffverfahren auf dieses System und System mit einem solchem Speicher
Circuit integré de mémoire dynamique synchrone, méthode d'accès d'une telle mémoire et système comprenant une telle mémoire

(30) Priority: 29.11.1988 US 277637; 29.11.1988 US 278333; 29.11.1988 US 277687
(43) Date of publication of application: 11.06.1997
(62) Divisional of application: 94116991.4
(73) Proprietor: MATSUSHITA ELECTRIC INDUSTRIAL CO., LTD., Kadoma-shi, Osaka 571-8501 (JP)
(72) Inventor: Harlin, Roy Edward, Santa Clara , California 95054 (US); Herrington, Richard Arthur, Ford Collins, Colorado 80525 (US)
(74) Representative: Schwabe - Sandmair - Marx

(56) References cited:
- JP-A- 61 288 240
- US-A- 4 546 451
- US-A- 4 712 190

## Description

### BACKGROUND OF THE INVENTION

### 1. Field of the invention:

The invention relates to a synchronous semiconductor memory integrated circuit connected to a first bus for specifying a location in a memory block and for inputting/outputting data, and a second bus for inputting a control input defining an operation mode of said synchronous semiconductor memory, furthermore a method for accessing said memory, and a system comprising such a memory, a circuit for accessing said memory, a first bus connecting said circuit to said memory for specifying a location in said memory and for conveying data and a second bus for connecting said circuit to said memory for conveying a control input defining an operation mode of said memory.

### 2. Description of the prior art:

With the cost per bit of a semiconductor memory and the price of computer systems dropping, personal work stations and other computer systems using graphics such as CAD/CAM systems are becoming more readily available. A crucial component in such systems is the dynamic video RAM which supports the graphics applications.

Conventional dynamic video RAMS, available on multichips, have a random port and a serial port enabling a computer to access the dynamic video RAM through the random port and enabling the serial port to deliver the necessary graphics information to drive, for example, a color monitor.

In designing dynamic video RAMS, several features are of critical importance.

First, it is important to package the video RAM on a single integrated circuit chip minimizing the number of external pins from the chip. Secondly, it is important to maximize the memory contained on the chip. Third, it is important to perform as many of the modification operations on chip to increase the speed, rather than having off chip hardware perform these operations at a much slower rate off the chip. Fourth, it is important to maximize the addressing capabilities of the data stored within the chip. The number of clock inputs controlling the random port of the video RAM leads to complexity and slower speed.

The following patents are representative of issued patents involving dynamic RAMs commercially available. In each of these patents, no provision is made for incorporating both the conventional image mode addressing and the vector mode addressing of the present invention onto the chip carrying the RAM. The conventional image mode addressing is slow when a vertical line in the screen is to be modified. Each scan line in memory must be addressed even though each scan line contains only one pixel in the vertical line to be modified. Hence, a substantial number of scan lines in memory must be addressed to modify the line. Under the teachings of the present invention, the vertical line can be addressed as a vertical vector in a page and, therefore, only those vertical vectors comprising the vertical line need to be addressed. This substantially speeds up the addressing for vertical lines in the dynamic video RAM.

In each of these patents, further, no provision is made for incorporating the drawing or replacement rules onto the chip carrying the RAM. Rather, in order to modify a given line of information stored in the RAM, the information to be modified must be read out from the dynamic video RAM and modified off chip according to the acquired logical operation. The present invention performs the drawing or replacement rule with circuitry located on the chip and further is able to selectively mask the areas of modified information to be read back into the RAM.

The U.S. patent issued to Novak, et al. (USP 4,688,197) sets forth a video computer system having a RAM chip with a shift register connected to its serial output terminal which is actuated by a first clock and a second clock is utilized to load the serial chip register.

The U.S. patent to Redwine et al. (USP 4,689,741) pertains to the same invention as the Novak patent but provides for coupling of data between column lines and the chip register to prevent two or more different data bits from simultaneously appearing.

The U.S. patent to Thaden (USP 4,665,495) sets forth a single chip dynamic RAM controller and CRT controller system arrangement. This invention minimizes the control circuit of prior systems thus eliminating potential bottle necks at the RAM by utilizing a single controller. A related U.S. patent also issued to Thaden et al. is USP 4,656,596. The RAM of Thaden resides on a chip separated from the controller chip and the control signals are sent to the RAM.

The U.S. patent to Bruce (USP 4,546,451) sets forth a dynamic RAM which permits "page mode" addressing horizontal or vertical vector addressing. While bruce shows a graphics controller device (GDC) clock, this clock is delivered from the RAM chip to the separate GDC. More importantly, the separate GDC must provide the load, count enable and other control signals directly to the RAM chip.

The U.S. patent to Voss (USP 4,646,270) sets forth a video graphic dynamic RAM having the capability of serially reading out data at a high rate of speed while performing standard RAM operations.

A need exists for a dynamic video RAM which performs both vector mode addressing (i.e., horizontal and vertical vectors) and image mode addressing on a single chip containing high capacity memory, contains the necessary hardware to perform on-chip modification of the stored video information, and accomplishes this with a minimum number of external pins.

There is no disclosure in any one of the above patents of circuitry to perform drawing rule modification on chip with the random access memory.

In the target specification of the Hitachi HM53462 Multi Port DRAM, logic operation and masking occur on a single chip. However, in this approach the system must first deliver the logic operation to the chip and then cycle to address the memory, deliver the new source data, read from memory and then modify the read information.

A need exists not only for providing the drawing rule and masking circuitry on the chip with the RAM but also to maximize the performance by delivering the drawing rule with the addresses to the chip at the same time.

EP-A-0 197 413 shows that locations in a RAM sharing a common row address but with different column addresses are sequentially accessed. Thus the modification of a vertical or horizontal line requires addressing the locations of the RAM for a plurality of times.

Supplementarily, US-A-4,442,503, US-A-3, 996, 559 and WO-A 94 03970 show RAM devices which are comparable with this according to EP-A-0 197 413.

In the above patents, no provision is made for utilizing a single clock on the random port side of the RAM to control the operation of the RAM including the loading of information into the address and data registers, the operation of the RAM and the modification of the information in the RAM.

US 4,712,190 discloses a self-timed random access memory circuit designed on an IC chip including a random access memory including addressable storage locations, address decoding circuitry, data input and output circuitry and write enable circuitry, input latches connected to chip input terminals which store data, address and operation control signals from off-chip circuitry in response to a timing signal, also from the off-chip circuitry. In response to the timing signal, an output latch on the chip stores data from the random access memory for transmission to output terminals, where the data is available to the off-chip circuitry. The input and output latches permit the self-timed random access memory circuit to perform in a pipelined manner. The chip additionally includes circuitry that generates the control signals, in response to the latched control signals, with the correct timing for controlling the random access memory.

JP 61-288240 A discloses a memory having an arithmetic means. Plural kinds of arithmetic operations are conducted by an arithmetic circuit, and a mask control circuit is provided for inhibiting a substantial change in data in the memory, irrespective of the operations of the arithmetic circuit, when it is brought into a masking state. In a preset operation mode control signals for the arithmetic circuit and the mask control circuit are received from the outside. For accessing a specific memory location the well-known method using a RAS (row address strobe) signal and a CAS (column address strobe) signal is described. The timing control circuit generates a plurality of timing signals using the RAS and CAS signals to control the row address buffer R-ADB and the column address buffer C-ADB.

US 4,546,451 discloses a raster graphic refresh memory architecture having a "page mode" of operation of dynamic random-access memory integrated circuit devices which require two separate device addresses for random access to a storage location therein but permit in "page mode" a first address corresponding to a set of storage locations to be maintained while changing the second address for more rapid access. The memory is organized so that a portion of the second device address is allocated to the least significant bits of one dimension of the display address and another portion of the second device is allocated to the least significant bits of another dimension of the display address, thereby forming a two-dimensional cell of storage locations on a single page corresponding to a region on the display. The page can be extended by using a plurality of random-access memory devices and selecting one of the devices using the least significant bits of one dimension of the display address. An addressing scheme is provided which permits simultaneous "page mode" writing of data into multiple storage locations representing contiguous pixels of the display. A mechanism is also provided for reading back data from a plurality of storage locations representing contiguous pixels on the display and storing the data in a temporary storage-shift register for subsequent manipulation.

### SUMMARY OF THE INVENTION

The synchronous semiconductor memory integrated circuit of this invention which overcomes the above-discussed and numerous disadvantages and deficiencies of the prior art comprises. a memory block including a plurality of memory cells for storing information; an input for receiving an external clock signal; address input means for receiving a first address and a second address through said first bus, said address input means providing said first address as an output in response to a first edge of said external clock signal, said address input means providing said second address as an output in response to a second edge of said external clock signal; access information input means for receiving access information through said first bus, said access information being valid when said operation mode is a predetermined operation mode, said access information controlling a method for determining a second plurality of memory cell locations to be accessed in said memory block based- on said second address among a first plurality of memory cell locations selected based on said first address in said memory block, said access information input means providing said access information as an output in response to a third edge of said external clock signal; access means for accessing said second plurality of memory cell locations in said memory block corresponding to said first address and said second address provided by said address input means and said access information provided by said access information input means; and control means for receiving said control input defining said operation mode through said second bus, and for controlling operations of said address input means, said access information input means and said access means in response to said control input on an edge of said external clock signal, wherein the first edge is different from the second edge of said external clock signal.

Suitable embodiments of such a synchronous semiconductor memory integrated circuit are defined by the features of subclaims 2 to 10.

According to a second aspect of the present invention in such a synchronous memory integrated circuit connected to a first bus for specifying a location in said memory and for in putting/outputting data, and a second bus for inputting a control input defining an operation mode of said memory, said memory including a memory block having a plurality of memory cells for storing information; address input means for receiving a first address and a second address; access information input means for receiving access information which is valid when said operation mode is a predetermined operation mode, said access information controlling a method for determining a second plurality of memory cell locations to be accessed in said memory block based on said second address among a first plurality of memory cell locations selected based on said first address in said memory block; and an input for receiving an external clock signal, a method for accessing said memory is provided, comprising the steps of: a) receiving said first address through said first bus, and providing said first address as an output of said address input means in response to a first edge of said external clock signal; b) receiving said second address through said first bus, and providing said second address as an output of said address input means in response to a second edge of said external clock signal; c) receiving said access information through said first bus and providing said access information as an output of said access information input means in response to a third edge of said external clock signal; d) accessing said second plurality of memory cell locations in said memory block corresponding to said first address, said second address and said access information, wherein first edge is different from the second edge of said external clock signal.

Suitable embodiments of such a method are defined by subclaim 12.

According to a further aspect of the present invention a system comprising a memory, a circuit for accessing said memory, a first bus connecting said circuit to said memory for specifying a location in said memory and for conveying data and a second bus for connecting said circuit to said memory for conveying a control input defining an operation mode of said memory, is defined by the following features: said circuit comprising means for providing a first address and a second address on said first bus, means for providing said control input defining said operation mode of said memory on said second bus, and means for providing access information on said first bus, said access information being valid when said operation mode is a predetermined operation mode, said access information controlling a method for determining a second plurality of memory cell locations to be accessed in said memory based on said second address among a first plurality of memory cell locations selected based on said first address in said memory, said first address being valid on said first bus on a first edge of a clock signal and said second address being valid on said first bus on a second edge of said clock signal, said access information being valid on said first bus on a third edge of said clock signal, and said control input being valid on said second bus on an edge of said clock signal; and said memory being a synchronous semiconductor memory integrated circuit comprising: a memory block including a plurality of memory cells for storing information; an input for receiving said clock signal; address input means for receiving said first address and said second address through said first bus, said address input means providing said first address as an output in response to said first edge of said clock signal, said address input means providing said second address as an output in response to said second edge of said clock signal; access information input means for receiving said access information through said first bus, said access information input means providing said access information as an output in response to said third edge of said clock signal; access means for accessing said second plurality of memory cell locations in said memory block corresponding to said first address and said second address provided by said address input means and said access information provided by said access information input means; and control means for receiving said control input through said second bus, and for controlling operations of said address input means, said access information input means and said access means in response to said control input on an edge of said clock signal, wherein the first edge is different from the second edge of said external clock signal.

Suitable embodiments of such a system are defined by the features of claims 14 to 16.

Such a dynamic (video) random access memory can be used for video purposes and has an architecture for addressing vectors in a dynamic (video) random access memory placed on an integrated circuit chip, said dynamic (video) random access memory being connected to a bus (90, 100), said architecture on said integrated circuit chip comprises a memory (1300) for storing (video) information, said memory having a plurality of "n" x "m" bit of pages (PG), each of said pages having defined page column (PC) and page row (PR) locations in said memory, each said page containing a plurality of horizontal (610) and vertical (600) vectors, each said horizontal vector being defined by a vector row location in said page and each said vertical vector being defined by a vector column in said page, address means (1360) connected to said bus for receiving the address of a horizontal or vertical vector in a page of said memory to be modified, said address comprising: (a) a first plurality of bits for defining the page row of said addressed page, (b) a second plurality of bits for defining the page column of said addressed page, and (c) a third plurality of bits for defining the addressed vector in said addressed page, data means (1340) connected to said bus for receiving source data, and control means (1366, 1360, 1354, 1336) connected to said memory, said address means, and said data means for modifying the stored (video) information with said source data at the addressed vector in said memory.

The dynamic (video) random access memory of this invention is connected to a bus (90, 100), and comprises an integrated circuit chip, a memory (1300) on said chip for storing (video) information, said memory having a plurality of "n" x "m" bit pages (PG), each said page containing a plurality of horizontal and vertical vectors, address means (1360) on said chip and connected to said bus for receiving the address of a horizontal or vertical vector in said page of said memory, said address comprises (a) a first plurality of bits for defining the addressed page, and (b) a second plurality of bits for defining the addressed horizontal or vertical vector in said addressed page, data means (1340) on said chip and connected to said bus for receiving source data, and control means (1366, 1360, 1354, 1336) on said chip and connected to said memory, said address means, and said data means for modifying the stored (video) information with said source data at the addressed vector location in said memory.

The dynamic (video) random access memory of this invention can have an architecture for addressing in either the image and vector modes, and is connected to a bus (90, 100), said architecture comprises a memory (1300) for storing (video) information, said memory being addressed with either vector and image addresses, said memory: (a) in said vector address mode, having a plurality of pages (PG), each of said pages having defined page column (PC) and page row (PR) locations in said memory, each said page containing a plurality of horizontal (610) and vertical (600) vectors, each said horizontal vector being defined by a vector row location in said page and each said vertical vector being defined by a vector column in said page, (b) in said image address mode, having a plurality of scan lines, each of said scan lines containing a plurality of words, address means (1360) connected to said bus for receiving the address mode (V/I), and either the vector mode address for a horizontal or vertical vector to be modified in said memory or the image mode address of a word to be modified in said memory, said vector mode address comprises (a) a first plurality of bits for defining the page row of said addressed page, (b) a second plurality of bits for defining the page column of said addressed page, and (c) a third plurality of bits for defining the addressed vector in said addressed page, said image mode address comprises (a) a first plurality of bits for defining the scan line being addressed, and (b) a second plurality of bits for defining the addressed word in said addressed scan line, data means (1340) connected to said bus for receiving the source data for modifying the stored (video) information at said vector or image addresses, and control means (1366, 1360, 1354, 1336) connected to said memory, said address means, and said data means for modifying the stored (video) information with said source data at the image mode or vector mode addresses.

Such a dynamic (video) random access memory of this invention is placed on a single integrated circuit chip and connected to a bus (90, 100), and comprises means for storing (video) information in a memory located on said chip having a plurality of pages (PG), each of said pages having defined page column (PC) and page row (PR) locations in said memory, each said page containing a plurality of horizontal (610) and vertical (600) vectors, each said horizontal vector being defined by a vector row location in said page and each said vertical vector being defined by a vector column in said page, means for receiving on said chip the address of a vector in a page of said memory to be modified over said bus, said address comprises (a) a first plurality of bits for defining the page row of said addressed page, (b) a second plurality of bits for defining the page column of said addressed page, and (c) a third plurality of bits for defining the addressed vector in said addressed page, means for receiving on said chip the source data over said bus for modifying the stored (video) information at said addressed vector in said addressed page, and means for modifying on said chip the stored (video) information with said source data at the addressed vector location in said memory.

The dynamic (video) random access memory of this invention can be connected to a random bus and to a serial bus, and comprises a single integrated circuit chip (10) connected to said serial and random buses, a memory (1300) on said chip for storing (video) information, said memory being addressed in serial data transfer, vector, and image modes of operation, said memory: (a) in said vector address mode, having a plurality of pages (PG), each said page containing a plurality of horizontal (610) and vertical (600) vectors, (b) in said image address mode, having a plurality of scan lines, each of said scan lines containing a plurality of scan words, (c) in said serial data transfer mode, having a plurality of partial scan lines, each of said partial scan lines containing a plurality of partial scan words, address means (1360) on said chip and connected to said random bus for receiving the mode of operation and (1) the vector mode address for a vector in said memory, (2) the image mode address for a scan line in said memory, and (3) the serial data transfer address for the partial scan line in said memory, random port control means (1366, 1360, 1354, 1336, 1340) connected to said memory and said address means for accessing information at the memory locations of the image mode or vector mode addresses, said random control means reading said memory at said serial data transfer addresses, and serial port control means (1304, 1306, 1314) connected to said memory for delivering said read information at said serial data transfer address to said serial bus.

The dynamic (video) random access memory of this invention has an architecture, placed on an integrated circuit chip, and connected to a bus (90, 100, 140); said architecture on said integrated circuit chip comprises a memory (1300) for storing information, address means (1360) connected to said bus for receiving the address of vector data to be modified in said memory, data means (1340) connected to said bus for receiving drawing rule data and source data, said drawing rule data designating the logical operation for modifying said vector data of stored information and said source data being used to perform said modification, said data means further receiving the START and STOP location data which are the beginning and ending bit locations in said vector data, drawing rule means (1354, 1360) connected to said memory for obtaining said vector data to be stored and connected to said data means for obtaining said drawing rule data, said drawing rule means logically combining said vector data of stored information and said source data according to said drawing rule logical operation to modify said vector data to be stored, write mask means (1336) connected to said data means for obtaining said START and STOP locations and connected to said memory for allowing said writing of said logical combination into said memory only between said START and STOP bit locations of said vector data, and control means (1366) connected to said drawing rule means and said memory for activating said drawing rule means to perform said logical combination, and said control means finally writing said modified vector data of information resulting from said logical combination into memory only between said START and STOP bit locations.

The dynamic random access memory of this invention is placed on an integrated circuit chip, and connected to a bus (90, 100, 140); said dynamic random access memory has an architecture on said integrated circuit chip comprising a memory (1300) for storing information, address means (1360) connected to an address bus for receiving during a first time interval the address of vector data of said stored information in said memory to be modified, data means (1340) connected to a data bus for receiving during said first time interval the drawing rule data, said drawing rule data designating the logical operation for modifying said vector data, drawing rule means (1354, 1360) connected to said memory for obtaining said vector data of information to be stored and connected to said data means for obtaining said drawing rule, said drawing rule means logically combining during a second time interval said vector data of stored information and said source data according to said drawing rule logical operation, control means (1366) connected to said memory, address means, data means and drawing rule means for activating during said second time interval said drawing rule means for performing said logical combination, said control means writing during a third time interval said logically combined information into memory.

The dynamic (video) random access memory of this invention is placed on a single integrated circuit chip, and connected to a bus (90, 100, 140), comprises means for receiving on the chip from the bus and during a first time interval: (a) the address of vector data to be modified stored in the memory, (b) the drawing rule data containing the logical operation for modifying the stored vector data, (c) the START and STOP locations for modifying the vector data between identified beginning and ending bit locations, means for receiving on the chip from the bus and during a second time interval following the first time interval source data to be logically combined with the addressed vector data, means for modifying on the chip and during a third time interval following the second time interval the addressed vector data with the source data based upon the logical operation of the received drawing rule data, and means for writing the memory during a fourth time interval following the third time interval between the START and STOP bit locations with the modified vector data of information.

The dynamic random access memory of this invention has a random port (1200), connected to a bus (90, 100, 140), said bus carrying a single clock, said improved random port comprises address means (1330, 1360) connected to said bus for receiving the address of stored information in said memory, source means (1340) connected to said bus for receiving source data, output means (1338) connected to said memory for delivering said addressed stored information from said memory to said bus, modification means (1336, 1354 and 1360) connected to said memory for obtaining said addressed stored information and connected to said source means for obtaining said source data, said modification means combining said addressed stored information with said source data to modify said stored information and to write said modified information back into said memory, and control means (1366) connected to said bus and to said address means, said source means, said output means, said modification means, and said memory; said control means being responsive to the receipt of said single clock from said bus for controlling the operation of said address means, said source means, said output means, said modification means, and said memory.

The dynamic random access memory of this invention is connected to a random port bus (90, 100, 140) and to a serial port bus (50, 70), said memory comprises said random port bus carrying addresses, data, random port control enables, and a single random port clock signal, said serial port bus carrying serial data, serial port control enables, and a single serial port clock signal, a single integrated circuit chip connected to said serial and random port buses, a memory (1300) on said chip for storing information, random port means (1200) on said chip and operative with said single random port clock signal and receptive of said random port control enables from said random port bus for receiving from said addresses, said addresses being (1) the random access addresses for said memory and (2) the serial data transfer addresses for said memory, said random port means being connected to said memory for accessing information at the memory locations of said received random access addresses, said random port means reading information from said memory at said received serial data transfer addresses, and serial port means (1210) on said chip and operative with said single serial port clock signal and receptive of said serial port control enables for delivering said read information from said memory at said serial data transfer address to said serial port bus.

The dynamic random access memory of this invention is placed on a single integrated circuit chip and includes a random port, said random port interfaces said dynamic random access memory with a random port bus (90, 100, 140), said memory further includes a control means which comprises means for receiving one set of a plurality of sets of control signals from the random port bus, each set of said plurality of sets corresponding to a different mode of operation for said random port, means for configuring a predetermined sequence of internal control enable pulses for controlling the operation of the random port corresponding to one set of said control signals received, means for receiving a single clock signal having a preselected frequency over the random port bus, and means for executing the configured predetermined sequence of internal enable pulses with the clock pulses of the received single clock so that the random port operates in the mode of operation corresponding to the received set of control signals.

The present invention, in a preferred embodiment, uses a 1,310,720 bit dual ported, dynamic memory having random and serial ports. There is well over one million bits of stored information stored in the memory. The random port supports the two modes of access: a vector access to a 32 by 32 bit page and an image access to a 16 by 1 word. The serial port consists of eight, thirty-two bit dynamic latches providing 256 consecutive bits for a screen refresh. The dynamic (video) RAM of the present invention incorporates built-in drawing rule cycles, a clocked random port for synchronous operation, optimized vector operation and sixteen bit read and write access.

In the preferred embodiment, the (video) RAM is packaged on a chip where the random port is accessed by an eleven pin address, a sixteen pin data path, chip select, vector/image select, read/write signal and random port clock. The serial port is supported by the serial clock, serial output enable, load signal and four serial output data lines. The chip is powered by at least two Vcc and two Vss lines. While the preferred invention has at least forty-four pins on this chip, more pins could be added.

In the vector mode of operation, the dynamic (video) RAM of the present invention writes both horizontal and vertical vectors to a thirty-two by thirty-two bit page. The cells within a page in the preferred embodiment are addressed as a thirty-two bit vertical or horizontal vector column or row. However, the cells could be any desired selection such as "n" x "m". The address selects the page location of the vector and the row-column of the vector within the page. The data lines carry START and STOP locations within the page and the horizontal/vertical orientation of the vector within the cell. The drawing rule of the vector is also carried on the data lines with a source of the vector always defaulting to one. Once selected, a vector page can be accessed as a series of page mode cycles specifying column or row and START and STOP locations. In the preferred embodiment, vectors are write only.

Under the image mode of operation, the dynamic (video) RAM of the present invention allows the random access memory port array to be written and read directly. On writes, the address input of the address lines selects a thirty-two by thirty-two bit page, the page identical to that selected in vector mode. The row within the page is identical to the vector row selected while in the vector mode. The word is masked according to the START and STOP locations specified in the first data mode of the cycle. This first data word also carries the drawing rule specification. The second data word of the cycle carries the sixteen bit word image word. Reads are also sixteen bits wide and the address is specified in the write cycle, with the addition of the least significant address to control whether the least or the most significant word in the row is placed on the sixteen bit data bus. The START, STOP, and drawing rule have no effect on read cycles. Page mode works for both reads and writes, allowing the full thirty-two by thirty-two page to be accessed in one page cycle. The present invention provides a conventional internal refresh to the memory.

Finally, transferring data to the shift register is accomplished by executing a cycle with the vector/image line asserted to vector and the read/write line asserted to read. This places the contents of 256 cells in a dynamic latch ready to be loaded into the serial port register. While only 256 cells are written to an internal latch, the full 8,192 cells are accessed and refreshed during the serial data transfer. The 256 bits transferred during the transfer are referred to as a partial scan line and replacement rules have no effect on serial data transfer.

All of the above random port operations (i.e., not the transfer through the serial port) are accomplished through the use of a single clock pulse delivered to a random state machine and in conjunction with the enable levels of the V/I (vector-image), R/W (read-write), refresh, and the CS (chip-select) control lines.

Thus, the invention described herein makes possible the objectives of:
(1) providing a dynamic (video) random access memory in which the addressing for vertical lines is speeded up;
(2) providing a dynamic (video) random access memory in which a vertical line can be addressed as a vertical vector in a page and, therefore, only those vertical vectors comprising the vertical line need to be addressed;
(3) providing a dynamic (video) random access memory which can perform both vector mode addressing (horizontal and vertical vectors) and image mode addressing on a single chip containing high capacity memory;
(4) providing a dynamic (video) random access memory which contains the necessary hardware to perform on-chip modification of the stored (video) information;
(5) providing a dynamic (video) random access memory which has a minimum number of external pins;
(6) providing a dynamic (video) random access memory which has a circuitry to perform drawing rule modification on a chip with the random access memory;
(7) providing a dynamic (video) random access memory which can provide the drawing rule and masking circuitry on a chip with the random access memory and maximize the performance by delivering the drawing rule with the address to the chip at the same time;
(8) providing a dynamic random access memory which can utilize a single clock on the random port side of the memory to control the operation of the memory including the loading of information into the address and data registers, the operation of the memory and the modification of the information in the memory; and
(9) providing a dynamic random access memory which can minimize the number of signal paths to and from the chip while providing for a faster operation.

### BRIEF DESCRIPTION OF THE DRAWINGS

This invention may be better understood and its numerous objects and advantages will become apparent to those skilled in the art by reference to the accompanying drawings as follows:
Figure 1 is a block diagram of a system incorporating the dynamic (video) RAM of the present invention.
Figure 2 illustrates the screen of the color monitor 20 of the system of Figure 1 and a partial scan line.
Figure 3 illustrates the serial data transfer address of the present invention.
Figure 4 illustrates the most significant address and least significent address of the serial data transfer address of Figure 3.
Figure 5 sets forth the page layout of the screen of the color monitor 20 of the present invention.
Figure 6 shows vectors within an individual page.
Figure 7 is the format for a page address.
Figure 8 shows the most significent address and least significant address bits of the page address of Figure 7.
Figure 9 shows the image mode addressing scheme of the color monitor of the present invention.
Figure 10 shows the format of the image address.
Figure 11 shows the most significant and least significent address portions of the image address of Figure 10.
Figure 12 illustrates the structure of a single chip of the dynamic (video) RAM of the present invention.
Figure 13 sets forth the circuit block diagram of the dynamic (video) RAM chip of the present invention.
Figure 14 sets forth the format of the data inputs for the image mode of operation.
Figure 15 sets forth the format for the data inputs for the vector mode of operation.
Figure 16 is an illustration of a vector mode operation.
Figure 17 is an illustration of an image mode operation.
Figure 18 shows the timing for serial data transfer.
Figure 19 shows the timing for vector write.
Figure 20 shows the timing for vector write, page mode.
Figure 21 shows the timing for image read/write.
Figure 22 shows the timing for image read/write, page mode.
Figure 23 shows the timing for image read modify write.
Figure 24 sets forth an implementation of a random port state machine.

### DESCRIPTION OF THE PREFERRED EMBODIMENTS

### 1. General Description

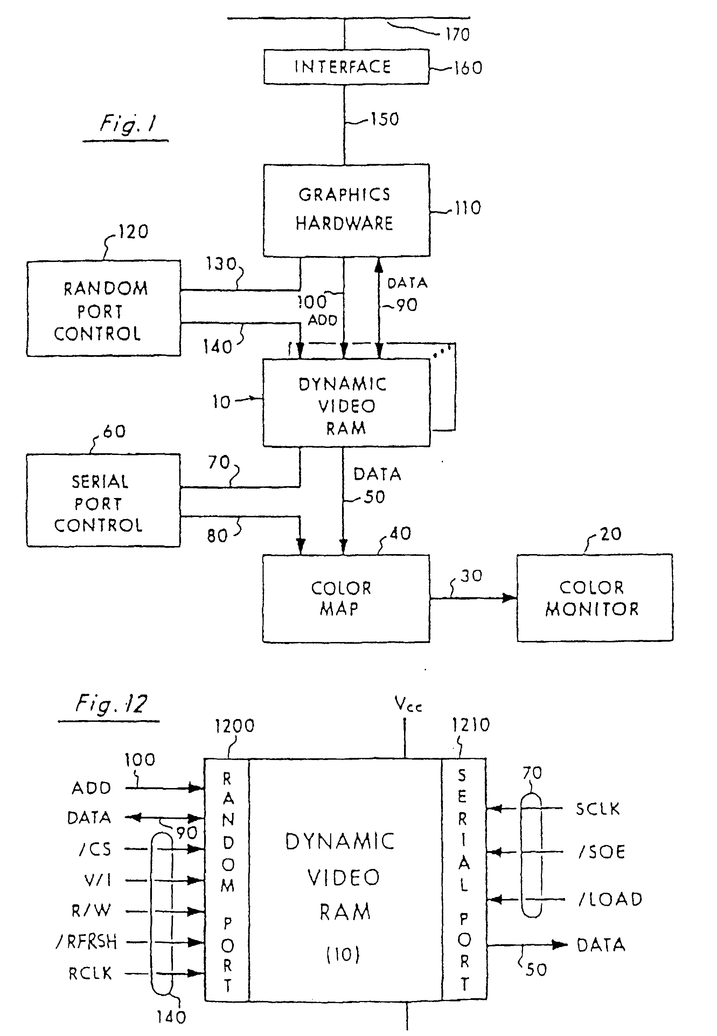

Figure 1 sets forth the dynamic video RAM 10 of the present invention in a system environment having a color monitor 20 interconnected over lines 30 with a color map circuit 40. The color map circuit 40 is in turn connected over video data bus 50 to the dynamic video RAM lO of the present invention. Both the dynamic video RAM 10 and the color map 40 are under control of a serial port control 60 over lines 70 and 80. The dynamic video RAM 10 is also interconnected over a data bus 90 and an address bus 100 to a graphics hardware circuit 110. A random port controller 120 controls the graphic hardware circuit 110 over lines 130 and the dynamic video RAM 10 over lines 140. The graphics hardware circuit 110 is interconnected over lines 150 to an interface circuit 160 which communicates with a standard bus 170.

The dynamic video RAM 10 of the present invention stores the image which is actually being displayed on the color monitor 20. The stored information in the video RAM 10 is delivered over the data bus 50, sequentially, to the color map circuit 40 for display on the monitor 20. The serial port control 60 controls the transfer of the stored information in the dynamic video RAM 10 to the color map 40.

When it is desired to change the stored information in the dynamic video RAM 10 in order to change the displayed image on the color monitor 20, appropriate commands come over bus 170 such as from a CPU or the like, not shown, and is received by the interface circuit 160 for delivery into the graphics hardware circuit 110. The random port control 120 controls the changing of the information stored in the dynamic video RAM based upon the information received by the graphics hardware from bus 150. The address for the information to be changed is delivered over address bus 100 and the data for the change is delivered over data bus 90. In this fashion, the dynamic video RAM information can be modified to change the image on the color monitor 20.

It is to be expressly understood that the system environment shown in Figure 1 is for purposes of illustration only and that the dynamic video RAM of the present invention could be utilized in other environments. For example, a color map and color monitor may not be present.

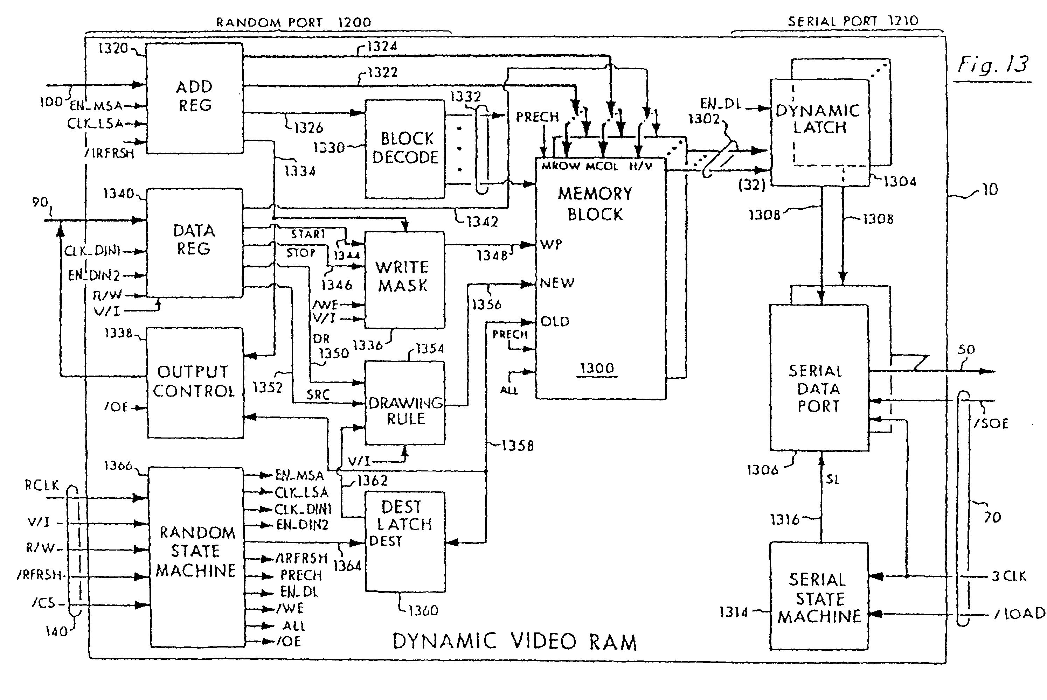

In the preferred embodiment of a single chip as shown in Figure 12, the random port bus comprises an address bus 100 which is eleven bits wide, a data bus 90 which is sixteen bits wide and a control bus 140 which is five bits wide. The serial port bus comprises a data bus 50 which is four bits wide and a control bus 70 which is three bits wide. Hence, the dynamic video RAM 10 has thirty-nine pins plus four pins for power and ground for a total of forty-four. The present invention as set forth next, however, is not limited to a configuration having this number of pins. As shown in Figure 1, a number of these single chips can be utilized in a system environment. The /CS control enable carried by control bus 140 selects which chip is accessed.

Three modes of addressing and operating the dynamic video RAM 10 over address bus 100 are present. They are (a) the serial data transfer mode, (b) the vector address mode, and (c) the image address mode. Each mode will be discussed in the following.

### a. Serial Data Transfer Mode

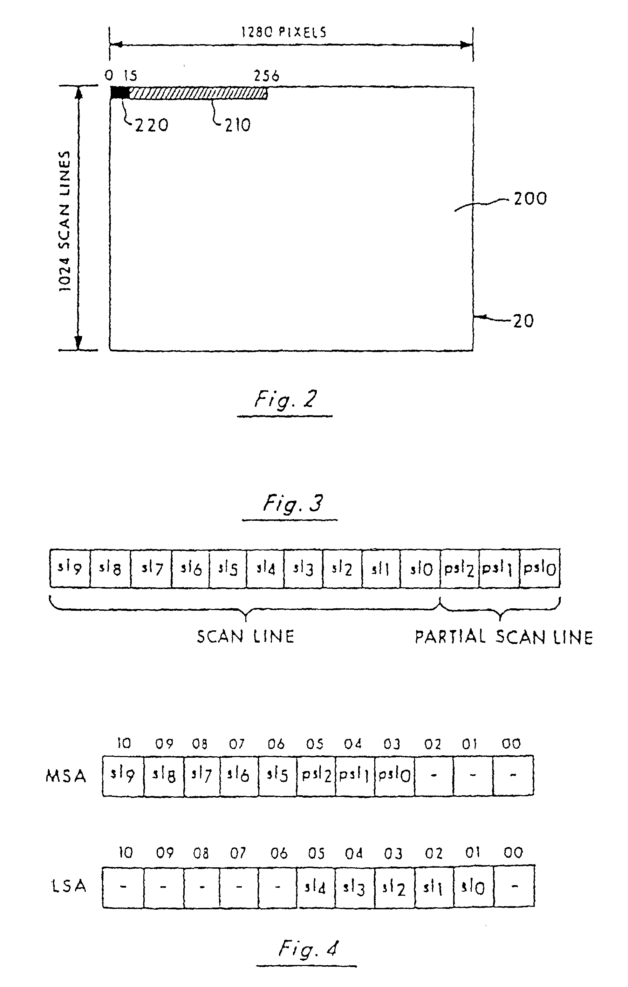

In Figure 2, the screen 200 of monitor 20 is shown. Screen 200 is conventional and may have, for example,1280 pixels across the screen in a horizontal line with 1024 scan or raster lines in the vertical direction. It is to be expressly understood that any configuration of pixels and scen lines could be used under the teachings of the present invention. In Figure 2, a partial scan line 210 is also shown. A "partial scan line" is defined herein to be 256 contiguous pixels in a scan line. A "word" is defined to be 16 pixels. Hence, a partial scan line contains 16 words. This corresponds to conventional image mode addressing found in other video RAM devices.

The dynamic video RAM 10 of the present invention is capable of being addressed over random port address bus 100 to perform serial port data transfers over data bus 50 under the serial port control 60. In Figure 3, the serial data transfer address is shown. The 1024 scan lines are selected by the ten bit scen line field and the partial scan lines 210 are selected by the three bit partial scan line field. A total of thirteen bits are required to perform serial data transfer addressing. Since address bus 100 is only eleven bits wide, two addresses are delivered as shown in Figure 4. The first transfer being the most significant address (MSA) and the second transfer being the least significent address (LSA). Again, it is to be expressly understood that the present invention is not limited to this number of bits or to this configuration of addressing.

Figures 2-4, therefore, show the addressing of the dynamic video RAM 10 of the present invention in the serial data transfer mode.

### b. Vector Addressing Mode

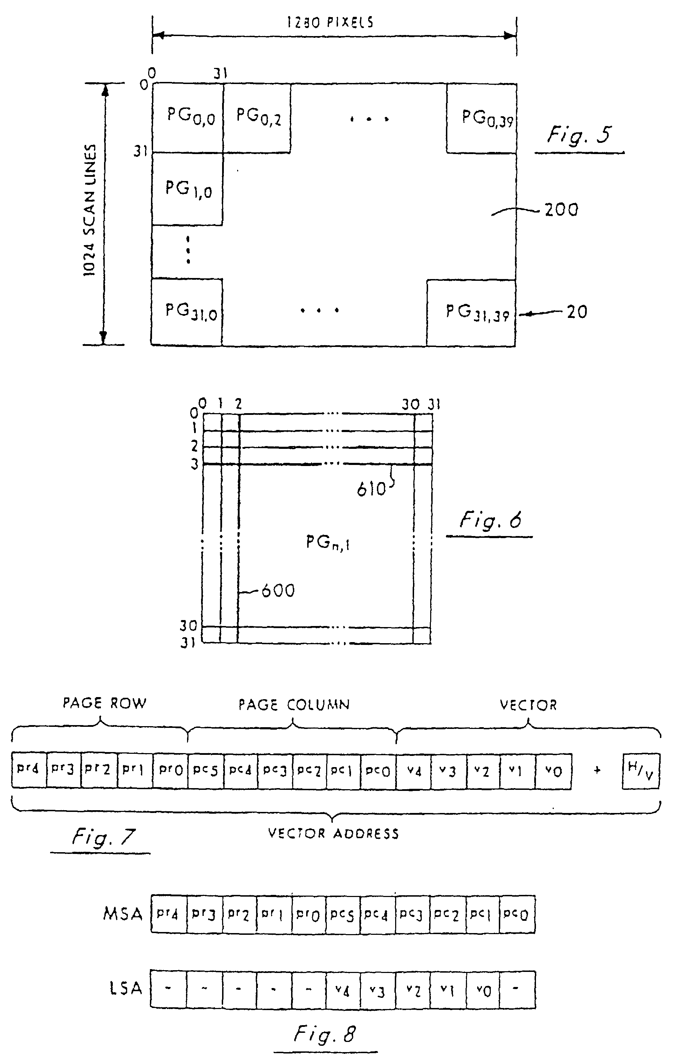

The present invention provides a mode of vector addressing wherein a page can be accessed either horizontally or vertically on the screen. This is shown in Figures 5-8.

A page is defined to be a 32 by 32 array of pixels. In Figure 5, the page PG (0,0) has 32 horizontal scan lines by 32 horizontal pixels. It is to be expressly understood that a page could be of any similar "m" x "n" configuration. The screen monitor of Figure 5 has 32 times 40 or 1280 pages. The term "page column" is defined to be the horizontal location of a page and the term "page row" is the vertical location of a page. For example, for page PG (31,39), the page column is 39 and the page row is 31. The page row in the preferred embodiment of 32 rows can be addressed by a 5 bit word. For example, the page row value for page PG (31,0) is 11111. Likewise, the 40 page columns, in the preferred invention of 1280 pixels can be addressed by a sixteen bit word.

Figure 6 shows an individual page PG (n,i). The term "vector column" identifies the horizontal location of a vector within a page. For example, vector 600 is located in vertical row 2. The term "vector row" is defined to mean the vertical location at a vector within a page. For example, vector 610 is located in column 3. In the vector mode addressing scheme of the present invention, one bit, the H/V bit is used to define whether the vector is horizontal 610 or vertical 600. Five bits are then utilized to locate the vector within the page. For example, for the vector 610, the H/V bit equals 1 to designate a horizontal vector and the remaining 5 bits are 00011. The vertical vector 600 has the H/V bit set to O and the remaining 5 bits are 00010.

The vector addressing scheme shown in Figures 5 and 6 is unique to the present invention and permits not only a select page PG to be addressed but also to address a vertical or horizontal vector within the page.

Therefore, the necessary page address, as shown in Figure 7 and in the preferred embodiment, is a 16 bit word having 5 bits to identify the page row bits to identify the page column, and 5 bits to identify the vector. The additional horizontal/vertical (H/V) bit identifies whether the vector is horizontal or vertical within the page. In this fashion, a specific vector such as either vector 600 or 610 in Figure 6 in a selected page on the screen 200 can be addressed.

Since the address bus 100 in Figure 1 is 11 bits wide, the graphics hardware 110 outputs the vector address of Figure 7 as two separate transfers. The first transfer being the most significant address (MSA) and the second address being the least significant address (LSA) both shown in Figure 8.

It is to be expressly understood that Figures 5 through 8 set forth one approach under the teachings of the present invention and that other bit layouts and address configurations could be used to accomplish the vector mode of addressing.

### c.Image Adress Mode

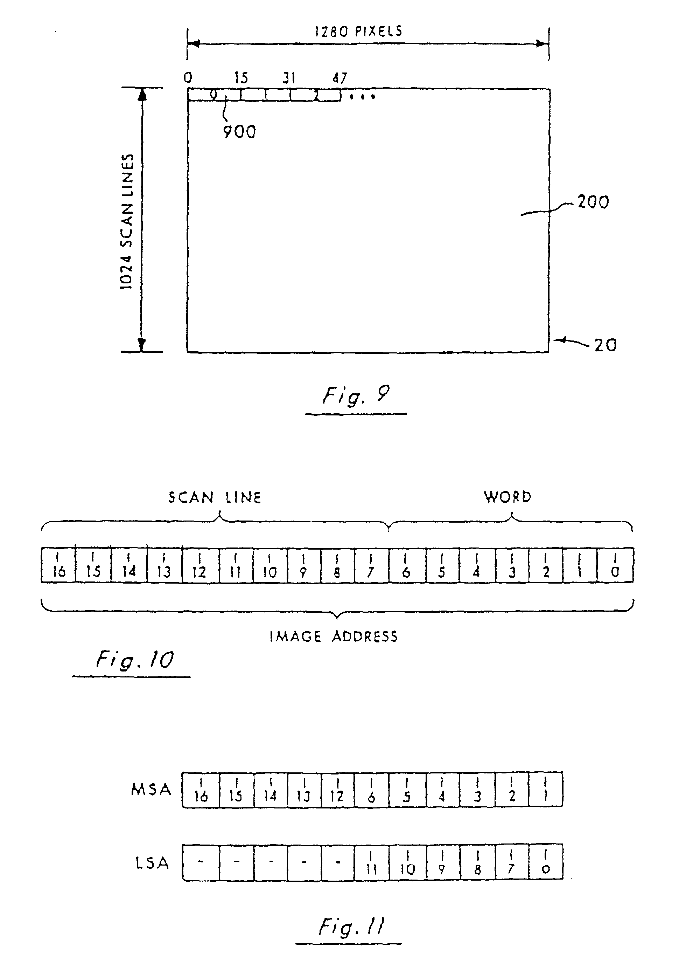

The present invention is also capable of image mode addressing as shown in Figures 9-11. To locate a scan line on screen 200 would require 10 bits in the example shown of 1024 scan liner. A scan line is defined as the set of contiguous pixels making up a complete scan line on a raster scan display. There are eighty 16 bit words in a scan line. Therefore, seven bits are required to locate a word in a given scan line. Hence, the image address as shown in Figure 10 has 10 bits to identify the scan line and 7 bits to identify a word within the scan line. Because of the structure of the video RAM of the present invention, the address bus 100 as shown in Figure 1 is limited to 11 bits and, therefore, as shown in Figure 11, the image address is transferred in an MSA cycle and an LSA cycle.

As discussed above, three modes of addressing occur on address bus 100. These three modes are serial data transfer (Figures 2-4), vector mode addressing (Figures 5-8) and image mode addressing (Figures 9-11) and cause the (video) RAM 10 of the present invention to operate in these different modes. The serial data transfer mode effectuates transfer of information from the RAM 10 over data bus 50. The vector and image modes permit changes to be made to the information stored within the RAM 10.

### d. Chip Configuration

In Figure 12, the dynamic (video) RAM 10 of the present invention is shown as a discrete single integrated circuit chip. With reference back to Figure 1, the random port side 1200 of the RAM 10 has the following pin designations:
1. Address Bus 100 (11 pins)
2. Data Bus 90 (16 pins)
3. /CS-chip select
4. V/I - Vector/Image Select
5. R/W - Read/Write Select
6. RFRSH - Refresh
7. RCLK - Random Port Clock

On the serial port side 1210 of the dynamic video RAM 10 the following pins are designated:
1. SCLK - Serial Clock
2. /SOE - Serial Output Enable
3. /LOAD - Load Signal
4. Data Bus (4 pins)

In addition, two voltage, Vcc, pins and two ground pins, Vss, are required.

The chip select signal (/CS) selects which chip is being selected. For example, in Figure 1, any number of chips 10 can be positioned within the system environment. If, for example, sixteen chips are required, then the appropriate /CS pin would be activated by the random port control 120.

As previously discussed, the vector-image signal (V/I) determined whether the chip is being addressed in the vector or image modes. In the preferred embodiment, when V/I is high, the chip is in the vector mode and when the V/I signal is low, the chip executes in the image mode.

The read/write signal (R/W) performs as follows. When R/W is high, the chip 10 is in the read mode and data appears on data bus 90. When R/W is low, the chip is in the write mode and the data is written into the memory found within chip 10. The following modes of operation occur within the chip 10:

**TABLE I**

| V/I | R/W | Cycle |
|---|---|---|
| 0 | 0 | image write |
| 0 | 1 | image read |
| 1 | 0 | vector write |
| 1 | 1 | serial data transfer |

The random port clock (RCLK) is a single clock signal delivered to the chip 10. All internal random port operations of the chip 10 are synchronized with and derived from this clock signal. This is the only clock signal to the random port and is preferably one megahertz.

The address signals on random port address bus 100 carries the bit addresses for the MSA and LSA addresses as shown in Figure 4 for serial data transfer, in Figure 8 for vector mode addressing, and in Figure 11 for image mode addressing.

The data appearing on random port data bus 90 is sixteen parallel bits and is delivered into the chip 10 as two sets of data - DIN1 and DIN2. This is shown in the following table

**TABLE II**

| Mode | DIN1 | DIN2 |
|---|---|---|
| Vector | DR, START/STOP, H/V | - |
| Image | DR, START/STOP | Read or Write |
| (Where DR = Drawing Rule, H/V = Horizontal/Vertical) | | |

(Where DR = Drawing Rule, H/V = Horizontal/Vertical)

Also delivered to the RAM 10 of the present invention from the random port control 120 is a /RFRSH which is used as an internal refresh signal.

The RAM 10 of the present invention also receives control signals from the serial port control 60 over serial port control bus 70. The SCLK signal is a single serial port clock, the /SOE is a serial output enable signal. When /SOE is low, serial read data appears on the data bus 50. The /LOAD is a data load signal. The present invention only uses a single clock on the serial port 1210 to transfer data to the serial port.

The two Vcc pins shown in Figure 12 provide power which in the preferred embodiment is plus five volts and the Vss pins are the two ground pins. More or less than two pins for power and ground can be used under the teachings of the present invention.

The single integrated chip shown in Figure 12 contains in the random port 1200 and in the serial port 1210 all of the necessary circuitry to operate the RAM in the three modes of operation (Serial data transfer, Vector addressing and Image Addressing). The random port is controlled through receipt of one of a plurality of sets of control enables over bus 140 which configure the RAM to operate in its various modes of operation. The delivery of the single clock RCLK then is used to produce the necessary internal control enables to execute the selected mode of operation.

The signals appearing on the pins shown in Figure 12 will now be discussed in the following detailed description of the internal configuration and operation of the dynamic video RAM 10 of the present invention. It is to be expressly understood that the pin number and selection represents only a preferred embodiment and that other embodiments may be designed within the teachings of the present invention.

### 2. Detailed Description

This section discusses the detailed structural embodiment of the dynamic (video) RAM chip 10 of the present invention and the preferred operation. The individual register, latch, shift, and other disclosed circuits are individually conventional in operation and design. The combined circuit layout, however, is unique and while one preferred layout is shown, it is to be expressly understood that other layouts based upon the teachings of this invention could be used.

### a. serial Port Side 1210 Configuration

The components of the dynamic (video) RAM 10 of the present invention are set forth in Figure 13 to include a plurality of memory blocks 1300. Each memory block 1300 is, in the preferred embodiment; 160 memory cells by 1024 memory cells. There are 8 memory blocks for a total of 1,310,720 cells on a single chip although it is to be expressly understood that any number could be used.

The output from the memory block 1300 is delivered over lines 1302 into a plurality of dynamic latches 1304. Each dynamic latch 1304 stores 32 bits of information as read from its respective interconnected memory block 1300. The eight latches, therefore, hold 256 bits or a partial scan line. The output of each dynamic latch 1304 is delivered to a respective serial data port register 1306 over interconnecting lines 1308. Each serial data port register 1306 contains a 32 bit register which is capable of delivering 4 bits, in a serial fashion, onto data bus 50 for delivery, for example, inlo the color map 40 as shown in Figure 1. The control signals 70 from the serial port control 60 are delivered into the serial state machine 1314. Which is interconnected over lines 1316 to the serial data port in order to control the serial reading of information from the dynamic latch 1304.

Hence, the dynamic latch 1304, the serial data port 1306, and the serial state machine 1314 constitute the serial port side 1210 of the dynamic (video) RAM 10 of the present invention.

### b. Random Port Side 1200 Configuration

The random port side 1200 includes an address register 1320 which is interconnected to the random port address bus 100 and is further connected over lines 1322 (eight bits) and 1324 (five bits) to the memory block 1300. The address register 1320 is also interconnected over lines 1326 (three bits) to a block decode circuit 1330 which is interconnected over lines 1332 to the memory block 1300. The address register is also interconnected over line 1334 to the write mask 1336 and to the output control 1338.

The data register 1340 is interconnected to the data bus 90 and is further interconnected over line 1342 (H/V bit) to the memory block 1300, over lines 1344 (START - five bits) and 1346 (STOP - five bits) to the write mask 1336. The write mask 1336 is further interconnected over lines 1348 (32 bits) to the memory block 1300. The data register 1340 is further interconnected over lines 1350 (four bits) and 1352 (sixteen bits) to the drawing rule circuit 1354 which in turn is interconnected over lines 1356 (thirty-two bits) to the memory block 1300.

The output control 1338 is also interconnected to the random port data bus 90 and is also interconnected over lines 1358 to the memory block 1300. Destination latch 1360 is also connected to lines 1358 and is further connected over lines 1362 (thirty-two bits) to the drawing rule circuit 1354 and over line 1364 to the random state machine 1366. The random state machine 1366 receives the random port control input signals over random port control bus 140.

Hence, the address register 1320, the block decode circuit 1330, the data register 1340, the write mask 1336, the output control 1338, the drawing rule circuit 1354, the destination latch 1360, and the random state machine 1366 constitute the random port side 1200 of the dynamic video RAM 10 of the present invention. While a preferred embodiment of the present invention is shown, variations to the design could be made under the teachings of the claimed invention. For example, the latch 1360 could be designed using strobed combinational logic to deliver or hold the stored video information.

### c. Serial Port Side 1210 Operation

The operation of the dynamic (video) RAM of the present invention will first be discussed with respect to the operation of the serial data transfer mode of operation wherein the information contained within the memory block 1300 is issued to generate the image, for example, on the color monitor 20 of Figure 1. This scan line transfer mode of operation utilizes the addressing techniques shown in Figures 2-4.

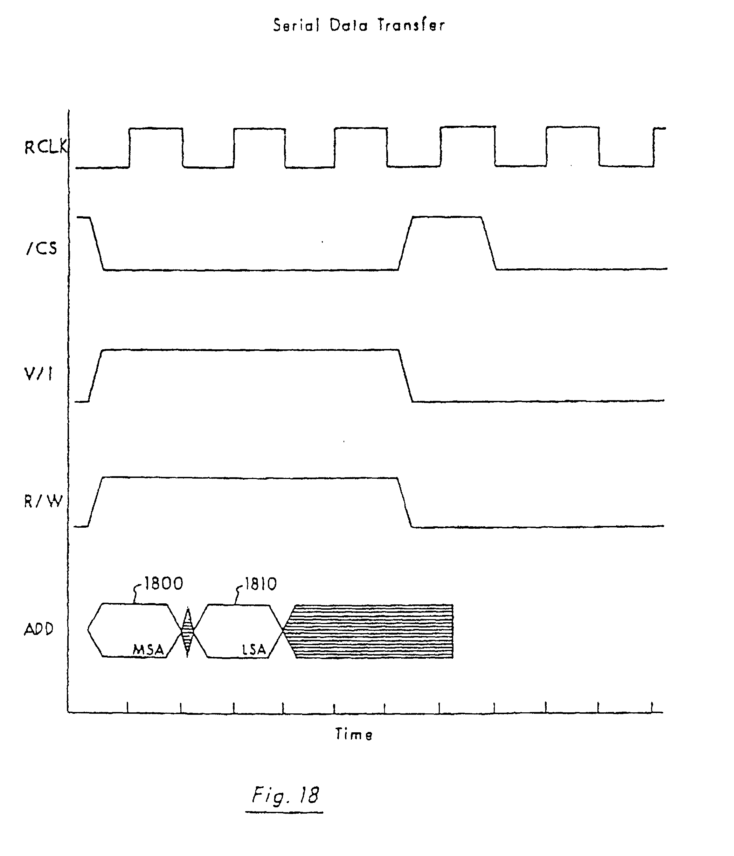

In the timing and control diagram of Figure 18, the RCLK, /CS, V/I, and R/W enables are delivered over random port control bus 140 from the random port control 120. The address, ADD, is delivered over bus 100 from the graphics hardware 110. The /CS signal selects which dynamic video RAM chip 10 is being activated. In this mode of operation, i.e., serial data transfer, the R/W bit is high to read the memory block 1300. When a serial data transfer occurs, the V/I bit set high (see Table I) (i.e., vector or image) is also selected and as shown in Table I the vector mode is selected. Hence, the address (MSA and LSA) of the data to be transferred from the memory block 1300 to the dynamic latch 1304 is contained on bus 100-see Figure 4. The single clock signal RCLK causes the random state machine 1366 to input the address (MSA and LSA) into the address register 1320 during a first time interval (i.e., at times 1800 and 1810) as shown in Figure 18. When it is desired to read the memory block 1300 so that the contents can be serially delivered to the color map 40, the transfer of the addressed partial scan line for a screen refresh occurs in the following manner. Thirty two bits of information from each of the eight memory blocks 1300 are read over lines 1302 into the dynamic latches 1304. The dynamic latch 1304 receives a signal over line EN-DL from the random state machine 1366 indicating that it is to read the data from the memory block. All eight dynamic latches are so enabled and each will read in 32 bits for a 256 bit partial scan line. After reading, EN-DL is appropriately activated to deliver the read information over lines 1308 into the serial data port 1306. Again, this is a parallel transfer of 32 bits of information for each of the eight serial shift registers. The serial data port 1306 comprises shift registers. Each of the eight serial data ports 1306 is under control of the serial state machine 1314 and the serial clock SCLK. When the serial data port 1306 is enabled over line SL, each clock signal transfers out four bits from a given serial data port 1306 to data bus 50.

The transfer of the data occurs in the following fashion. Serial state machine 1314 has a counter contained therein which counts the serial clock pulses SCLK. Hence, as the SCLK pulses come in, they are delivered to the serial data port 1306 which after eight such pulses sequentially gates out the 32 bits stored therein, four bits at a time, to the video data bus 50. Then, the next eight SCLK pulees cause the output of the 32 bits out from that next memory block portion to the video data bus 50. In this fashion, the serial state machine 1314 is capable of causing the serial data port to output the stored data from eech of serial data port 1306 until a partial scan line is output from the serial data port 1306. After a partial scan line is output, a /LOAD signal is received over serial port control bus 70 to the serial state machine 1314 and over line 1316 to load from the dynamic latch all of the serial data port 1306 with the data for the next partial scan line. The /SOE input to serial data port 1306 enables the multiplexer to deliver the information four bits at a time to the color map 40.

It is to be expressly understood that other conventional configurations for the serial port could be utilized under the teachings of the present invention. The serial port is asynchronous from the random port and can transfer data over bus 50 while the chip 10 is performing other operations.

### d. Random Port Side 1200 Operation

The operation of the random port 1200 of the dynamic (video) RAM 10 will now be explained.

The term "drawing rule" is defined to be a logical operator combining a "source" and a "destination" upon write to the memory block 1300. Drawing rules, in the preferred embodiment, are specified by the following table:

**TABLE III**

| Drawing Rule | Product |
|---|---|
| 0000 | clear (all zeroes) |
| 0001 | source and destination |
| 0010 | source and (not destination) |
| 0011 | source |
| | |
| 0100 | (not source) and destination |
| 0101 | destination |
| 0110 | source xor destination |
| 0111 | source or destination |
| | |
| 1000 | source nor destination |
| 1001 | source nxor destination |
| 1010 | not destination |
| 1011 | source or (not destination) |
| | |
| 1100 | not source |
| 1101 | (not source) or destination |
| 1110 | source nand destination |
| 1111 | set (all ones) |

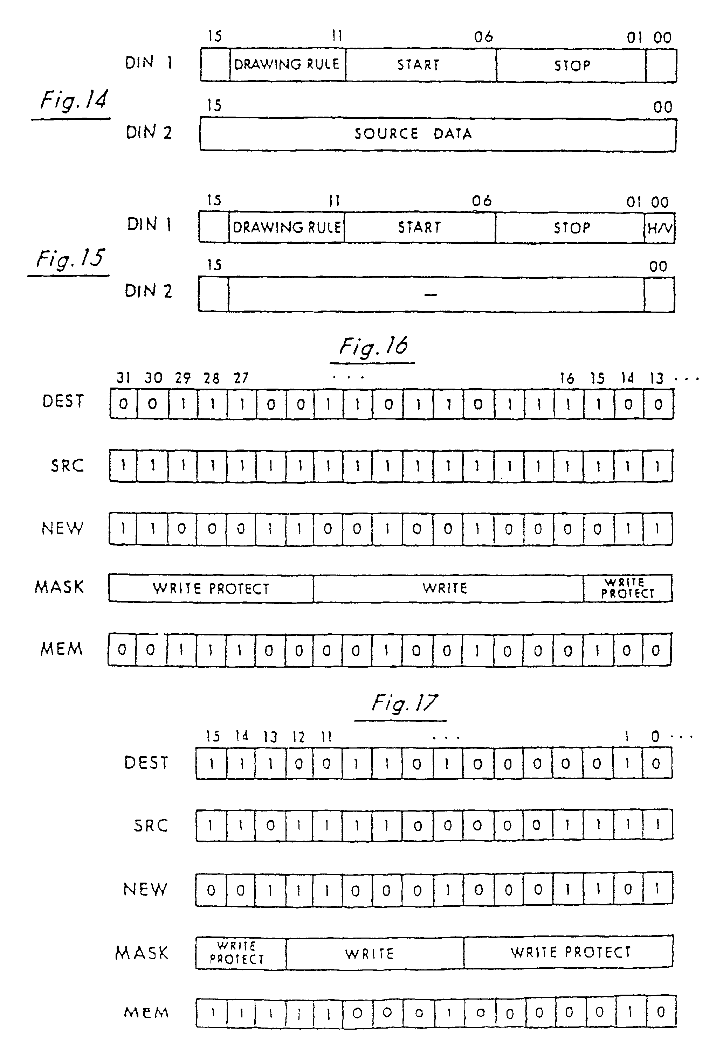

The operation of this table will be discussed in the following. In addition, the present invention incorporates two data cycles termed DIN1 and DIN2. In Figure 14, DIN1 and DIN2 are shown for the image mode of operation. Figure 15 shows DIN1 and DIN2 for the vector mode of operation.

Under the teachings of the present invention, the drawing rule function is incorporated directly in the dynamic video RAM chip 10. This permits faster modification of data within the memory block 1300. Conventional video RAM designs require that the information in the memory block be read out of the video RAM chip and be modified in another chip or circuit. After modification off the chip, it is rewritten back into the memory block. This is a slow process.

Under the teachings of the present invention up to 32 pixel elements can be changed in one operation. Conventional approaches use the image mode of operation whereas the present invention also incorporates the vector mode of operation wherein a horizontal or vertical vector"in a defined page can be modified and changed according to the selected drawing rule. This feature significantly speeds up the time for modification of the information contained in the memory block. For example, if under a conventional approach, a vertical line from screen 200 is to be modified, a number of horizontal scan lines would have to be read out of the memory in order to modify the one bit corresponding to the vertical line. Under the teachings of the present invention, only one vertical vector would have to be accessed and modified significently increasing the performance of the system over conventional approaches. It is estimated that current video RAM systems can process these vectors at the rate of 300,000 to 700,000 vectors per second. Under the teachings of the present invention, three to four million horizontal and vertical vectors per second can be processed.

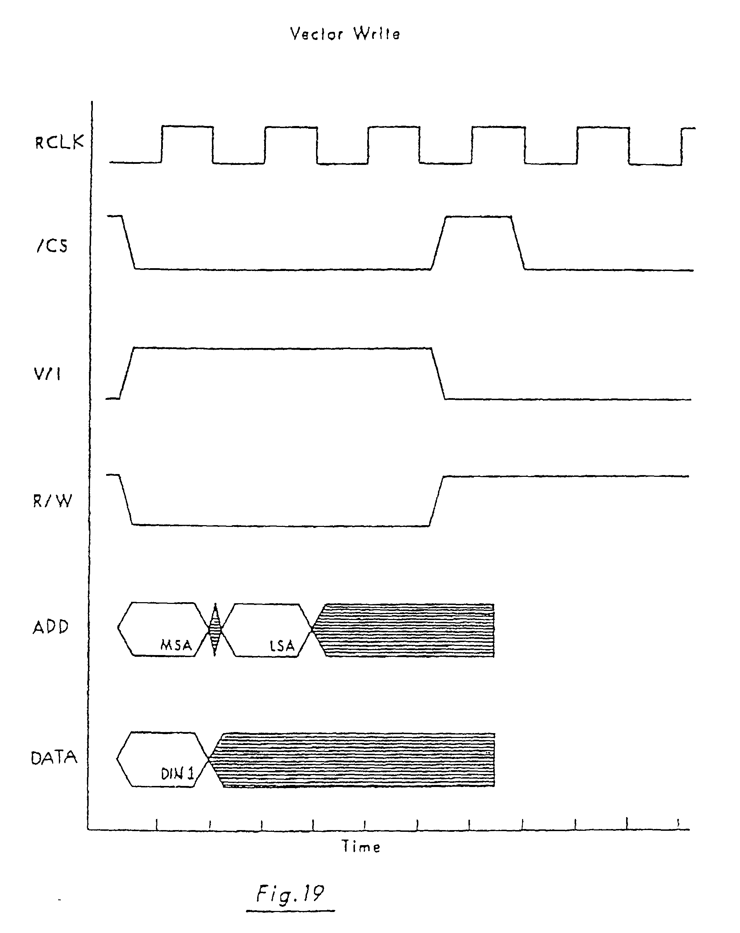

The speed up is due to the provision of the vector write mode of operation as will be discussed in the following. In the vector write mode of operation, the MSA and LSA addresses of Figure 8 are sequentially loaded into the address register 1320. This is shown in the timing diagram of Figure 19 where the /CS selects the proper chip, the V/I lead is high to select the vector mode, and R/W is low for write. Hence, the MSA and LSA of the address (Figure 8) are loaded into the address register 1320 as well as the drawing rule, start, and stop (Figure 15) over the random port data bus 90 into the data register 1340. The vector address (MSA and LSA) and the data (DIN1) is delivered during a first time interval.

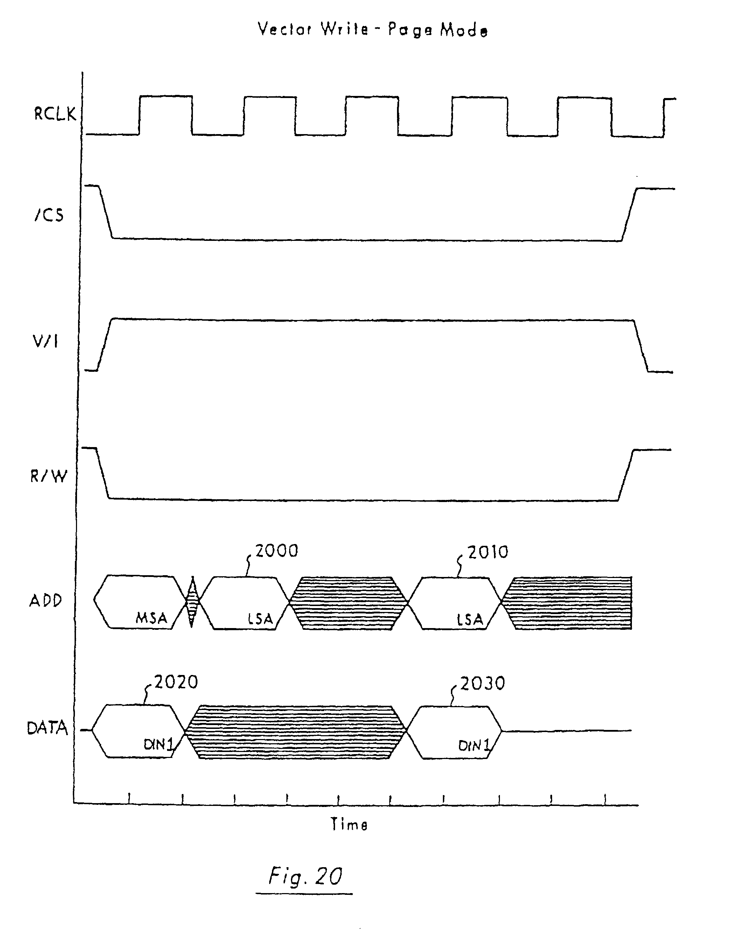

In Figure 20, the timing for vector write, page mode is shown. Here, the MSA remains the same whereas the LSA and the DIN are changed at times 2000 and 2010 for the LSA and time 2020 and 2030 for the DIN1. The MSA and LSA addresses containing the page row, page column and vector identification of Figure 8 are stored into the address register 1320. Eight bit outputs are delivered over lines 1322 to address the memory row of memory block 1300, five of the bits are delivered over lines 1324 to address the memory column of memory block 1300, and the three remaining bits are delivered over lines 1326 to the block decode circuitry 1330. The block decode circuitry 1330 is simply a one out of eight decode to selectively activate one of the eight memory blocks 1300.

In the vector mode of operation, DINl as shown in Figure 15 is read into the data register 1340 over data bus 90. DIN2 is not used in this mode. The five START bits are delivered over lines 1344 to the write mask 1336 and the five STOP bits are delivered over lines 1346 to the write mask 1336. The four drawing rule bits are delivered over lines 1350 to the drawing rule circuit 1354. The H/V bit is delivered from the data register 1340 over line 1342 to the memory block 1300.

The address register is of conventional register design that enables data to be read from a bus and to store the information in the register. The address register is enabled to read the most significant address by the MSA enable and the least significant address by the LSA enable. Likewise, the data register 1340 is of conventional design and reads in data from the data bus 90 and stores it internally upon being selectively enabled by the DIN1 and DIN2 enable lines. At this point and time, the address register 1320 and the data register 1340 have the necessary vector information to identify either a horizontal or vertical vector to perform a drawing rule operation on it. Other circuits could be designed to perform the above described address and data functions.

In reference back to Figures 5-8, it is seen that a selected vertical 600 or horizontal 610 vector is composed of 32 pixel elements or when resident in the memory block 1300, 32 memory cells. The START and STOP information conveys the precise portion of the vector to be modified according to the drawing rule. For example, if the desired place to start the modification within a vector is seven bits from the start of the vector, the START command would be 00111 and if the STOP location is the fifteenth bit, the STOP command would be 01111. The START and STOP information is delivered to the write mask which provides 32 possible write protect WP signals over lines 1348. Hence, in our example of starting at location 7 and stopping at location 15 in a 32 bit vector, the first seven bits would be activated in the write protect mode and the last sixteen bits would be activated in the write protect mode so that when NEW data is read back into memory over lines 1356 only the desired portion of memory cells between the START and STOP locations are written into the memory.

In Figure 16 is shown an example of performing a drawing rule operation in the vector write page mode. The address register 1320 addresses a specific horizontal or vertical vector in the memory block 1300. Whether or not the vector is horizontal or vertical is determined by the H/V signal on line 1342 which is the first bit in DINl of Figure 15. The OLD information is read out of the memory block on line 1358 and in Figure 16 is designated DEST for "destination". It is to be noted that information could be delivered through the output control 1338 to data bus 90 for delivery back into the system if desired or into the destination latch 1360. The appropriate enable signal DEST on line 1364 enables the destination latch 1360 to read in the OLD information.

All 32 bits of the destination information of Figure 16 are read into the latch 1360. The output 1362 of the destination latch 1360 is delivered as the destination input to the drawing rule circuit 1354. For vector mode operation, the SOURCE (SRC) signals on lines 1352 from the data register 1340 are set to all ones and are shown in Figure 16. The drawing rules are set forth in TABLE III.

In the example of Figure 16, the "not destination" drawing rule 1010 appears in the data register 1340. Hence, the OLD information or destination data DEST is inverted to result in a new modified vector which is termed NEW as shown in Figure 16. However, the writing of this information inlo the memory block occurs under control of the write mask 1336 and as previously explained, for our example, bits 31-26 and 15-0 are write protected. Only bits 25-16 of the NEW data can be written into memory. In a similar fashion, all of the logical functions of the drawings rules can be implemented for the entire vector or a portion thereof based upon the START and STOP information.

In the vector mode of operation, up to 32 pixel elements stored in memory block 1300 can be changed in one operation on chip. The present invention is capable of changing a vector located either horizontally or vertically as shown in Figure 6 through use of the H/V bit.

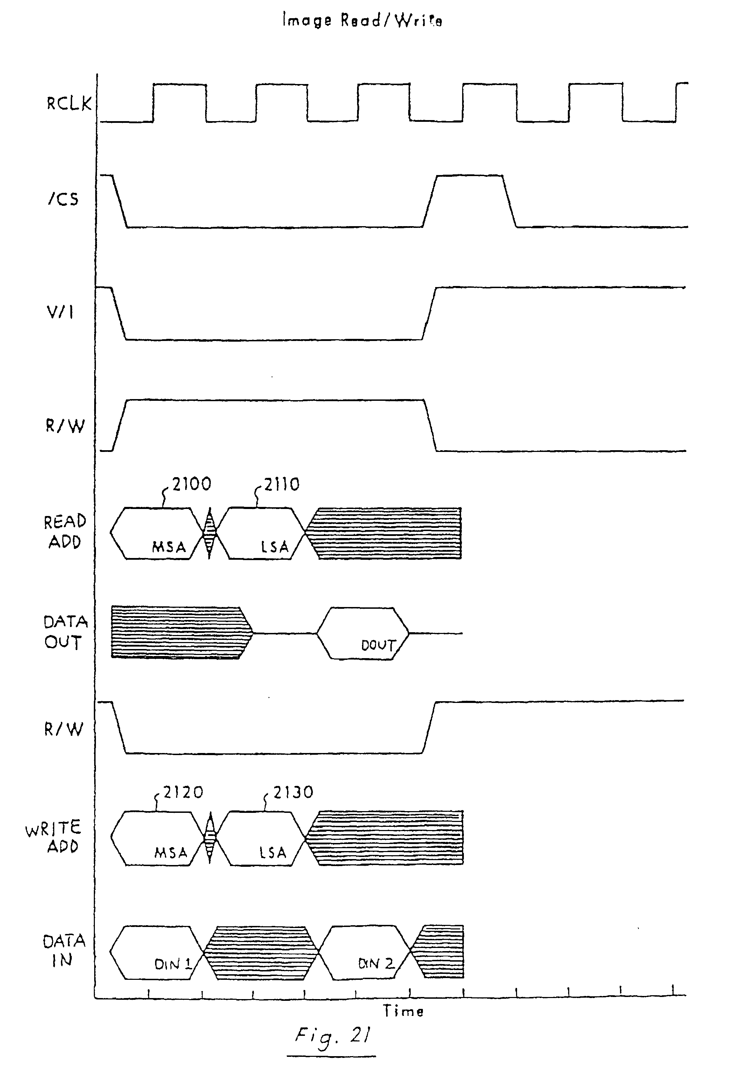

In the image mode of operation, the MSA and LSA addresses of Figure 11 are utilized. In Figure 21, the timing for both image read and image write is shown. Again /CS is properly enabled, and V/I is set low for the image mode. When R/W is set high for read, the read address (MSA 2100 and LSA 2110) is delivered over bus 100 and the data DOUT is read out over bus 90. When R/W is set low for write, the write address (MSA 2120 and LSA 2130) is delivered over bus 100 and the data DIN1 + DIN2 is delivered to the chip over bus 90. Here, the address and DIN1 (i.e., drawing rule and START/STOP) are delivered during the first time interval and DIN2 (i.e., source data) is delivered during the second time interval.

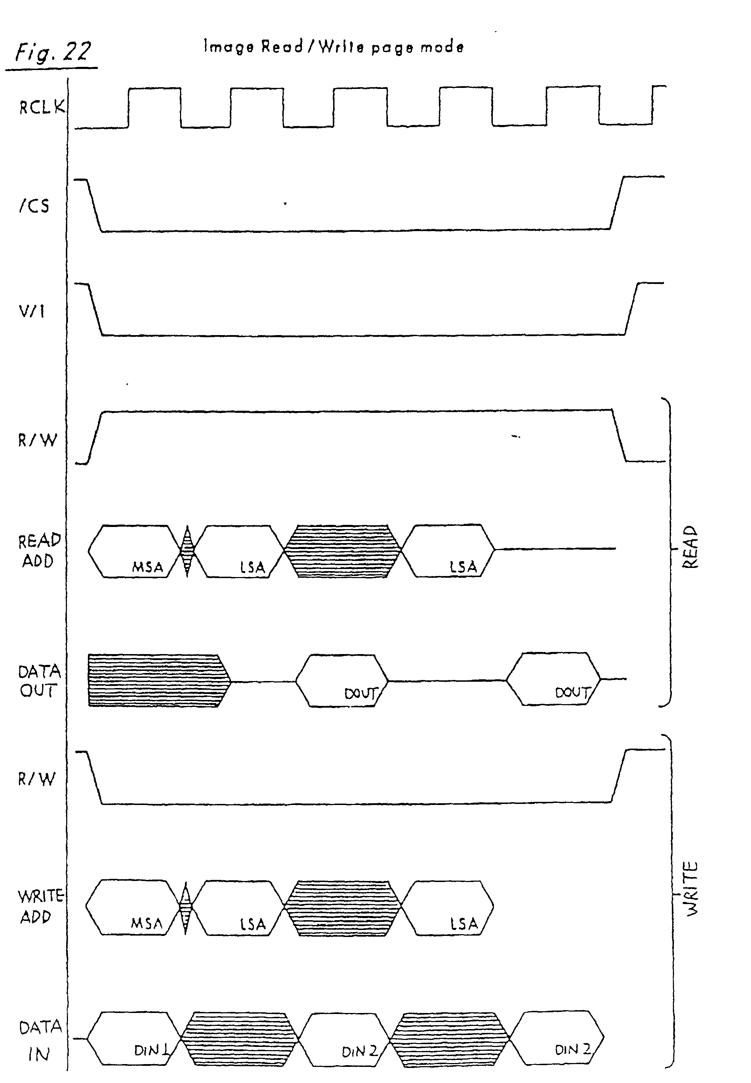

Figure 22 shows the timing for the image read 15 and write in the page mode. In the page mode, the LSA portion of the address changes. Hence, when reading, the changing of LSA causes new data DOUT to be read out. When writing R/W is low, new data is delivered right after delivery of the LSA.

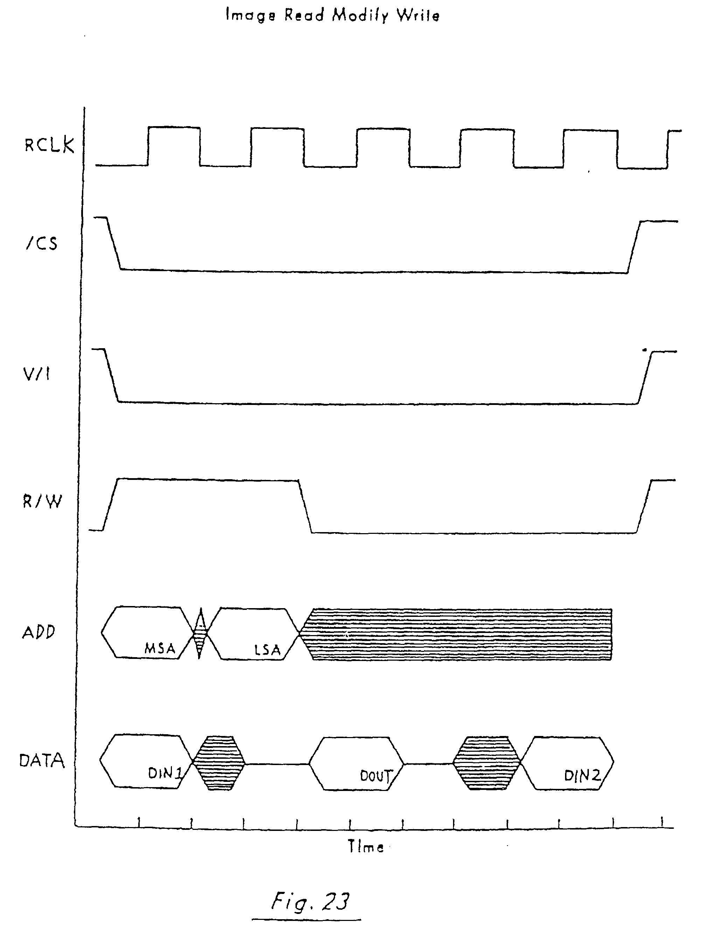

Finally, Figure 23 shows the timing for image read modify write wherein DIN1 of Figure 14 delivers the start, stop and drawing rule, DOUT is the data at the addressed location and DIN2 is the SOURCE data to be read into the chips. As before, the MSA and LSA are read inlo the address register 1320 and the corresponding DIN1 and DIN2 data configurations in Figure 14 are read into the data register 1340. In image mode of operation, a 16 bit word from a scan line is read from the memory block 1300 and is delivered into the destination latch 1360.

In Figure 17 is an example of a word called DEST read as OLD information from the memory block 1300. In the image mode operation, source data is delivered on DIN2 as shown in Figure 14 and designated SRC. Figure 17 shows an example of source data. This 16 bit source data SRC is delivered over lines 1352 into the drawing rule circuit 1354. If a drawing rule such as "exclusive-or" (DR = 0110) is utilized, circuit 1354 outputs on leads 1356 the NEW word as shown in Figure 17. Again, the image mode of operation can have a START and STOP location within the word and for masking purposes. In the example assume START equals 0011 and STOP equals 1000. Hence, the mask circuit 1336 provides write protect WP for the bits indicated as in MASK in Figure 17. What is written into memory is shown as NEW in Figure 17. The present invention is capable of performing drawing rule operations on chip in the image mode of operation.

As discussed above and as shown in Figure 23, the present invention delivers the drawing rule to integrated circuit chip with the delivery of the address during the same time interval and concurrently with the address cycle. This provides a significant speed up over the Hitachi approach which requires a separate time interval in which to deliver the drawing rule.

In the serial data transfer mode of operation, the MSA and LSA addresses of Figure 4 are utilized and read into the address register 1320. As set forth in TABLE II above, there are no corresponding DIN1 or DIN2 data words. When these MSA and LSA address words are read in, the appropriate scan line and scan line portion are read from the memory block 1300 into the the dynamic latch 1304 as previously discussed.

The random state machine 1366 is of conventional design and based upon the incoming set of control enables (i.e., V/I, R/W, RFRSH, and /CS) delivers, according to the pulses of the single clock RCLK, the following internal random port enable pulses:(1) EN-MSA and CLK-LSA to enable the reading of the most significant and least significant addresses on address bus 100 into the address register 1320, (2) CLK-DIN1 and EN-DIN2 to read in the data appearing on bus 90 into the data register 1340, (3) DEST to enable the destination latch 1360, (4) PRECH to precharge esch of the memory blocks 1300 in a conventional fashion, (5) EN-DL to enable the dynamic latch 1304 to read in data from the memory block 1300, (6) /WE to enable the WRITE mask 1336 to write protect the memory block 1300 based upon the START and STOP information, (7) ALL to access all of the memory blocks rather than a particular block as specified by the block select portion of the address (this is asserted during all regular and serial data transfer cycles), and (8) the OE signal which enables the output control 1338 to output data onto the data bus 90. While the preferred embodiment uses these internal enables other enables could be used in variations on this approach.

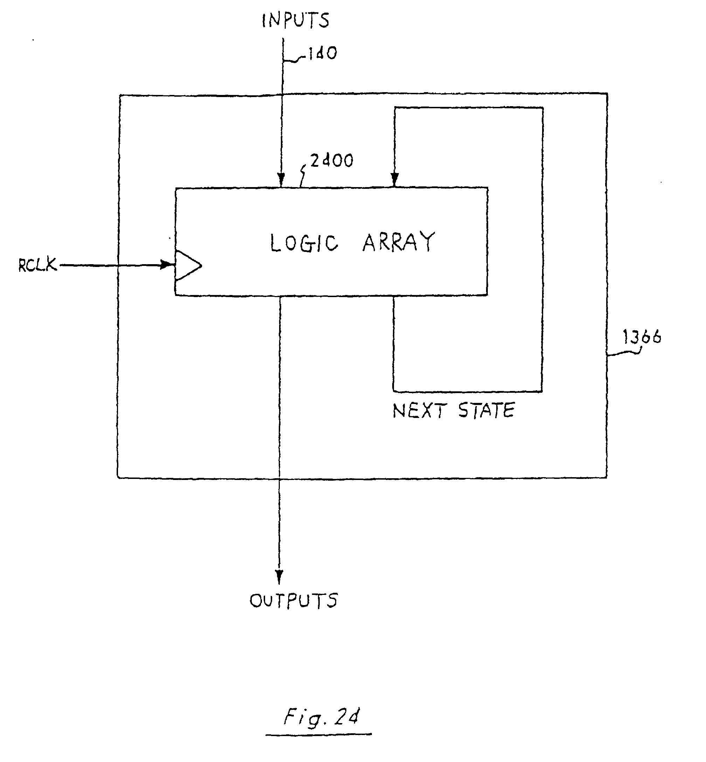

The random port state machine 1360 can comprise, for example, a programmable logic array shown in Figure 24 wherein the inputs 140 (i.e., a set of control enables) based upon the use of only a single clock RCLK to generate the Outputs set forth above. Internal to the random stete machine 1366 is a next stete for the logic array 2400. The next state table 5 is set forth as Table IV.

**TABLE IV**

| Input 3210 | State 3210 | Next State 3210 | Input 3210 | State 3210 | Next State 3210 | Input 3210 | State 3210 | Next State 3210 |
|---|---|---|---|---|---|---|---|---|
| 00xx | 0000 | 0100 | 0101 | 0000 | 1000 | 0111 | 0000 | 0001 |
| 00xx | 0001 | xxxx | 0101 | 0001 | xxxx | 0111 | 0001 | 0011 |
| 00xx | 0010 | xxxx | 0101 | 0010 | xxxx | 0111 | 0010 | 0000 |
| 00xx | 0011 | xxxx | 0101 | 0011 | xxxx | 0111 | 0011 | 0010 |
| 00xx | 0100 | 0110 | 0101 | 0100 | xxxx | 0111 | 0100 | xxxx |
| 00xx | 0101 | xxxx | 0101 | 0101 | xxxx | 0111 | 0101 | xxxx |
| 00xx | 0110 | 0111 | 0101 | 0110 | xxxx | 0111 | 0110 | xxxx |
| 00xx | 0111 | 0000 | 0101 | 0111 | xxxx | 0111 | 0111 | xxxx |
| 00xx | 1000 | xxxx | 0101 | 1000 | 1100 | 0111 | 1000 | xxxx |
| 00xx | 1001 | xxxx | 0101 | 1001 | 1011 | 0111 | 1001 | xxxx |
| 00xx | 1010 | xxxx | 0101 | 1010 | xxxx | 0111 | 1010 | xxxx |
| 00xx | 1011 | xxxx | 0101 | 1011 | 1100 | 0111 | 1011 | xxxx |
| 00xx | 1100 | xxxx | 0101 | 1100 | 1101 | 0111 | 1100 | xxxx |
| 00xx | 1101 | xxxx | 0101 | 1101 | 1100 | 0111 | 1101 | xxxx |
| 00xx | 1110 | xxxx | 0101 | 1110 | xxxx | 0111 | 1110 | xxxx |
| 00xx | 1111 | xxxx | 0101 | 1111 | 1011 | 0111 | 1111 | xxxx |
| 0100 | 0000 | 1000 | 0110 | 0000 | 1000 | 1xxx | 0000 | 0000 |
| 0100 | 0001 | xxxx | 0110 | 0001 | xxxx | 1xxx | 0001 | 0000 |
| 0100 | 0010 | xxxx | 0110 | 0010 | xxxx | 1xxx | 0010 | 0000 |
| 0100 | 0011 | xxxx | 0110 | 0011 | xxxx | 1xxx | 0011 | 0000 |
| 0100 | 0100 | xxxx | 0110 | 0100 | xxxx | 1xxx | 0100 | 0000 |
| 0100 | 0101 | xxxx | 0110 | 0101 | xxxx | 1xxx | 0101 | 0000 |
| 0100 | 0110 | xxxx | 0110 | 0110 | xxxx | 1xxx | 0110 | 0000 |
| 0100 | 0111 | xxxx | 0110 | 0111 | xxxx | 1xxx | 0111 | 0000 |
| 0100 | 1000 | 1001 | 0110 | 1000 | 1001 | 1xxx | 1000 | 0000 |
| 0100 | 1001 | 1011 | 0110 | 1001 | 1011 | 1xxx | 1001 | 0000 |
| 0100 | 1010 | xxxx | 0110 | 1010 | xxxx | 1xxx | 1010 | 0000 |
| 0100 | 1011 | 1001 | 0110 | 1011 | 1111 | 1xxx | 1011 | 0000 |
| 0100 | 1100 | 1101 | 0110 | 1100 | 1101 | 1xxx | 1100 | 0000 |
| 0100 | 1101 | 1001 | 0110 | 1101 | 1001 | 1xxx | 1101 | 0000 |
| 0100 | 1110 | xxxx | 0110 | 1110 | xxxx | 1xxx | 1110 | 0000 |
| 0100 | 1111 | 1011 | 0110 | 1111 | 1011 | 1xxx | 1111 | 0000 |

- Input₃: N_CS
- Input₂: N_RFRSH
- Input₁: V_I
- Input₀: R_W

In Table IV the input set format is: /CS, RFRSH, V/I, and R/W. As can be seen above for each different set of enables (INPUT) from the control bus 140, the random state machine produces a predetermined sequence as derived from the clock(RCLK) signal of the state table (STATE) to produce the control pulses which are defined next.

The output STATE signals are decoded from the state and are set forth in Table V.

**TABLE V**

| State | Output | | | | | | | | | | |
|---|---|---|---|---|---|---|---|---|---|---|---|
| 3210 | 10 | 9 | 8 | 7 | 6 | 5 | 4 | 3 | 2 | 1 | 0 |
| 0000 | 1 | 1 | x | 0 | x | x | 1 | 1 | 0 | 1 | 0 |
| 0001 | 0 | 0 | 0 | x | x | x | 1 | 1 | 1 | 1 | 0 |
| 0010 | 0 | 0 | x | x | x | x | 1 | 1 | 1 | 1 | 0 |
| 0011 | 0 | 0 | 1 | x | x | x | 1 | 1 | 1 | 1 | 1 |
| | | | | | | | | | | | |
| 0100 | 0 | x | x | x | x | x | 1 | 1 | 1 | 0 | 0 |
| 0101 | x | x | x | x | x | x | x | 1 | x | x | x |
| 0110 | 0 | x | x | x | x | x | 1 | 1 | 1 | 0 | 0 |
| 0111 | 0 | x | x | x | x | x | 1 | 1 | 1 | 0 | 0 |
| | | | | | | | | | | | |
| 1000 | 0 | 0 | 0 | 1 | x | x | 1 | 1 | 0 | 1 | 0 |
| 1001 | 0 | 0 | 1 | 0 | 1 | 1 | 1 | 1 | 0 | 1 | 0 |
| 1010 | x | x | x | x | x | x | x | 1 | x | x | x |
| 1011 | 0 | 0 | 0 | 0 | 0 | 0 | 0 | 1 | 0 | 1 | 0 |
| | | | | | | | | | | | |
| 1100 | 0 | 0 | 1 | 0 | x | x | 1 | 0 | 0 | 1 | 0 |
| 1101 | 0 | 0 | 0 | 0 | x | x | 1 | 1 | 0 | 1 | 0 |
| 1110 | x | x | x | x | x | x | x | 1 | x | x | x |
| 1111 | 0 | 0 | 1 | 1 | x | 1 | 1 | 1 | 0 | 1 | 0 |

The output relationships are set forth in Table VI.

**TABLE VI**

| | |
|---|---|
| Output₁₀ | PRECHARG |
| Output₉ | EN_MSA |
| Output₈ | CLK_LSA |
| Output₇ | CLK_DIN1 |
| Output₆ | EN_DIN2 |
| Output₅ | EN_DEST |
| Output₄ | N_WE |
| Output₃ | N_OE |
| Output₂ | ALL |
| Output₁ | N_IRFRSH |
| Output₀ | EN_DL |

The random port control signals set forth in Table VI become valid in the random port 1200, as shown in Figures 18 through 23 with the edges of the clock RCLK.

It can clearly be seen based upon this disclosure that only a single clock pulse RCLK controls the random port 1200 of the present invention. In other words, the random port 1200 of the present invention receives a set of control signals (i.e., INPUT of Table IV). Each set corresponding to a different mode of operation for the random port. The random state machine 1366 provides the sequential configuration (i.e., STATE and NEXT STATE of Table IV) for the received set. Each different set has a different sequential configuration resulting in its own predetermined sequence of internal control pulses (i.e., Table V). The single random port clock provides the timing signal necessary for executing the configured sequence of internal control pulses so that the random port operates in the mode of operation corresponding to the received set of control signals. It is to be expressly understood that while a preferred approach is set forth in Tables IV, V, and VI that other configurations of control signals and states can be defined under the teachings of the present invention to work on the provision of a single random port clock which in the present embodiment is 16.7 MHz.

Combining the aforesaid state tables with the timing diagrams of Figures 19 through 23, the method of modifying the stored information in the memory is based upon a series of time intervals which are derived from the single random clock RCLK. During a first time interval, the vector or image address as well as the drawing rule and the START and STOP locations are delivered to the chip. Based upon the set of control enables, the RCLK then sequences through the appropriate state table. Hence, during a second time interval, the addressed information is delivered from memory and the source data is delivered to the chip. During a third interval, the delivered information (i.e., DEST in Figures 16 and 17) is modified with the source data (i.e., SRC of Figures 16 and 17) based upon the drawing rule (i.e., Table III). During a fourth time interval, the modified information (i.e., NEW of Figures 16 and 17) is written between the START and STOP bit locations (i.e., MASK of Figures 16 and 17) into memory. Variations to this method are possible under the teachings of the present invention.

It is to be expressly understood that the preferred embodiment illustrates certain bit fields and patterns, certain pin configurations and layouts; however, the present invention is not so limited thereto that so under the teachings of the present invention other embodiments could be used.

While preferred embodiments of the present invention have been shown, it is to be expressly understood that modifications and changes may be made thereto and that the present invention is set forth in the following claims.

## Claims

1. A synchronous semiconductor memory integrated circuit connected to a first bus (90, 100) for specifying a location in a memory block (1300) and for inputting/outputting data, and a second bus (140) for inputting a control input defining an operation mode of said synchronous semiconductor memory, comprising:
a memory block (1300) including a plurality of memory cells for storing information;
an input (1366) for receiving an external clock signal (RCLK);
address input means (1320) for receiving a first address (MSA) and a second address (LSA) through said first bus (90, 100), said address input means (1320) providing said first address (MSA) as an output in response to a first edge of said external clock signal (RCLK), said address input means (1320) providing said second address (LSA) as an output in response to a second edge of said external clock signal (RCLK);
access information input means (1338, 1340) for receiving access information through said first bus (90), said access information being valid when said operation mode is a predetermined operation mode, said access information controlling a method for determining a second plurality of memory cell locations to be accessed in said memory block (1300) based on said second address (LSA) among a first plurality of memory cell locations selected based on said first address (MSA) in said memory block (1300), said access information input means (1338, 1340) providing said access information as an output in response to a third edge of said external clock signal (RCLK);
access means (1330, 1336, 1354, 1360); and
control means (1366);
**characterized in that**
the access means (1330, 1336, 1354, 1360) is for accessing said second plurality of memory cell locations in said memory block (1300) corresponding to said first address (MSA) and said second address (LSA) provided by said address input means (1320) and said access information provided by said access information input means (1338, 1340);
the control means (1366) is for receiving said control input defining said operation mode through said second bus (140), and for controlling operations of said address input means (1320), said access information input means (1338, 1340) and said access means (1330, 1336, 1354, 1360) in response to said control input on an edge of said external clock signal (RCLK),
wherein said first edge of said external clock signal (RCLK) being different from said second edge of said external clock signal (RCLK).

2. The memory of claim 1, wherein said access information input means (1338, 1340) receives said access information in a predetermined combination of said control input defining said operation mode.

3. The memory of claim 1 or 2, wherein said access means (1330, 1336, 1354, 1360) comprises:
write means for writing information to said memory block (1300) at said second plurality of memory cell locations corresponding to said first address (MSA), said second address (LSA) and said access information in response to a fourth edge of said external clock signal (RCLK).

4. The memory of claim 3,
wherein said control means (1366) supplies a first enable signal and a second enable signal to said address input means (1320) in response to said control input on an edge of said external clock signal (RCLK), supplies an access information enable signal to said access information input means (1338, 1340) in response to said control input on an edge of said external clock signal (RCLK), and supplies a write enable signal to said write means in response to said control input on an edge of said external clock signal (RCLK), each of said first enable signal, said second enable signal, said access information enable signal and said write enable signal being synchronous with an edge of said external clock signal (RCLK), and
wherein said address input means (1320) provides said first address (MSA) in response to said first enable signal, said address input means (1320) provides said second address (LSA) in response to said second enable signal, said access information input means (1338, 1340) provides said access information in response to said access information enable signal, and said write means writes said information in response to said write enable signal.

5. The memory of claim 4, wherein each of said first enable signal, said second enable signal, said access information enable signal and said write enable signal is in one of a first state and a second state.

6. The memory of claim 5, wherein
said control means (1366) comprises:
means for determining a next state in response to a current state and said control input on an edge of said external clock signal (RCLK); and
means for producing said first enable signal, said second enable signal, said access information enable signal and said write enable signal based on said next state.

7. The memory of one of claims 1 to 6, further comprising:
a serial port (1306), including:
means for receiving a serial port clock signal for controlling timing of said serial port; serial output means; and
transfer means for transferring serial information stored in said memory block (1300) to said serial output means in response to a fourth edge of said external clock signal (RCLK);
wherein said serial output means sequentially outputs portions of said serial information in response to respective edges of said serial port clock signal.

8. The memory of claim 7,
wherein said control means (1366) supplies a first enable signal and a second enable signal to said address input means (1320) in response to said control input on an edge of said external clock signal (RCLK), and supplies a transfer enable signal to said transfer means in response to said control input on an edge of said external clock signal (RCLK), each of said first enable signal, said second enable signal and said transfer enable signal being synchronous with an edge of said external clock signal (RCLK), and
wherein said address input means (1320) provides said first address (MSA) in response to said first enable signal, said address input means (1320) provides said second address (LSA) in response to said second enable signal, and said transfer means transfers said serial information in response to said transfer enable signal.

9. The memory of claim 8, wherein each of said first enable signal, said second enable signal and said transfer enable signal is in one of a first state and a second state.

10. The memory of claim 8 or 9, wherein
said control means (1366) comprises:
means for determining a next state in response to a current state and said control input on an edge of said external clock signal (RCLK); and ,
means for producing said first enable signal, said second enable signal and said transfer enable signal based on said next state.

11. In a synchronous memory integrated circuit connected to a first bus (90, 100) for specifying a location in said memory and for inputting/outputting data, and a second bus (140) for inputting a control input defining an operation mode of said memory, said memory including a memory block (1300) having a plurality of memory cells for storing information; address input means (1320) for receiving a first address (MSA) and a second address (LSA); access information input means (1338, 1340) for receiving access information which is valid when said operation mode is a predetermined operation mode, said access information controlling a method for determining a second plurality of memory cell locations to be accessed in said memory block (1300) based on said second address (LSA) among a first plurality of memory cell locations selected based on said first address (MSA) in said memory block (1300); and an input (1366) for receiving an external clock signal (RCLK),
a method for accessing said memory, comprising the steps of:
a) receiving said first address (MSA) through said first bus (90, 100), and providing said first address (MSA) as an output of said address input means (1320) in response to a first edge of said external clock signal (RCLK);
b) receiving said second address (LSA) through said first bus (90, 100), and providing said second address (LSA) as an output of said address input means (1320) in response to a second edge of said external clock signal (RCLK), wherein said first edge of said external clock signal (RCLK) is different from said second edge of said external clock signal (RCLK);
c) receiving said access information through said first bus (90, 100) and providing said access information as an output of said access information input means (1338, 1340) in response to a third edge of said external clock signal (RCLK);
d) accessing said second plurality of memory cell locations in said memory block (1300) corresponding to said first address (MSA), said second address (LSA) and said access information.

12. The method of claim 11, further comprising the step of repeating steps of b) and d).

13. A system comprising a memory, a circuit for accessing said memory, a first bus (90, 100) connecting said circuit to said memory for specifying a location in said memory and for conveying data and a second bus (140) for connecting said circuit to said memory for conveying a control input defining an operation mode of said memory,
said circuit comprising means for providing a first address (MSA) and a second address (LSA) on said first bus (90, 100), means for providing said control input defining said operation mode of said memory on said second bus (140), and means for providing access information on said first bus (90, 100), said access information being valid when said operation mode is a predetermined operation mode, said access information controlling a method for determining a second plurality of memory cell locations to be accessed in said memory based on said second address (LSA) among a first plurality of memory cell locations selected based on said first address (MSA) in said memory, said first address (MSA) being valid on said first bus (90, 100) on a first edge of a clock signal (RCLK) and said second address (LSA) being valid on said first bus (90, 100) on a second edge of said clock signal (RCLK), said access information being valid on said first bus (90, 100) on a third edge of said clock signal (RCLK), and said control input being valid on said second bus (140) on an edge of said clock signal (RCLK); and
said memory being a synchronous semiconductor memory integrated circuit comprising:
a memory block (1300) including a plurality of memory cells for storing information;
an input (1366) for receiving said clock signal (RCLK);
address input means (1320) for receiving said first address (MSA) and said second address (LSA) through said first bus (90, 100), said address input means (1320) providing said first address (MSA) as an output in response to said first edge of said clock signal (RCLK), said address input means (1320) providing said second address (LSA) as an output in response to said second edge of said clock signal (RCLK);
access information input means (1338, 1340) for receiving said access information through said first bus (90, 100), said access information input means providing said access information as an output in response to said third edge of said clock signal (RCLK); access means (1330, 1336, 1354, 1360) and control means (1366), **characterized in that**
the access means (1330, 1336, 1354, 1360) is for accessing said second plurality of memory cell locations in said memory block (1300) corresponding to said first address (MSA) and said second address (LSA) provided by said address input means (1320) and said access information provided by said access information input means (1338, 1340); and
the control means (1366) is for receiving said control input through said second bus (140), and for controlling operations of said address input means (1320), said access information input means (1338, 1340) and said access means (1330, 1336, 1354, 1360) in response to said control input on an edge of said clock signal (RCLK) wherein said first edge of said clock signal (RCLK) is different from said second edge of said clock signal (RCLK).

14. The system of claim 13, wherein said access means (1330, 1336, 1354, 1360) comprises:
write means for writing information to said memory block (1300) at said second plurality of memory cell locations corresponding to said first address (MSA), said second address (LSA) and said access information in response to a fourth edge of said clock signal (RCLK).

15. The system of claim 14,
wherein said control means (1366) supplies a first enable signal and a second enable signal to said address input means (1320) in response to said control input on an edge of said clock signal (RCLK), supplies an access information enable signal to said access information input means (1338, 1340) in response to said control input on an edge of said clock signal (RCLK), and supplies a write enable signal to said write means in response to said control input on an edge of said clock signal (RCLK), each of said first enable signal, said second enable signal, said access information enable signal and said write enable signal being synchronous with an edge of said clock signal (RCLK), and wherein said address input means (1320) provides said first address (MSA) in response to said first enable signal, said address input means (1320) provides said second address (LSA) in response to said second enable signal, said access information input means (1338, 1340) provides said access information in response to said access information enable signal, and said write means writes said information in response to said write enable signal.

16. The system of one of claims 13 to 15,
wherein said first bus (90, 100) includes an address bus (100) for conveying said first address (MSA) and said second address (LSA) and a data bus (90) for conveying said data.

## Patentansprüche

1. Integrierte Schaltung mit synchronem Halbleiterspeicher, welcher mit einem ersten Bus (90, 100) verbunden ist, zum Spezifizieren einer Stelle in einem Speicherblock (1300) und zum Eingeben/Ausgeben von Daten, und einem zweiten Bus (240) zum Eingeben einer Steuereingabe, welche einen Betriebsmodus des synchronen Halbleiterspeichers definiert, aufweisend:
einen Speicherblock (1300), welcher eine Mehrzahl von Speicherzellen zum Speichern einer Information enthält;
einen Eingang (1366) zum Empfangen eines externen Taktsignals (RCLK); eine Adresseneingabevorrichtung (1320) zum Empfangen einer ersten Adresse (MSA) und einer zweiten Adresse (LSA) über den ersten Bus (90, 100), wobei die Adresseneingabevorrichtung (1320) die erste Adresse (MSA) als eine Ausgabe zur Verfügung stellt in Reaktion auf eine erste Flanke des externen Taktsignals (RCLK), die Adresseneingabevorrichtung (132) stellt die zweite Adresse (LSA) als eine Ausgabereaktion auf eine zweite Flanke des externen Taktsignals (RCLK) zur Verfügung;
eine Zugriffsinformations- Eingabevorrichtung (1338, 1340) zum Empfangen einer Zugriffsinformation über den ersten Bus (90), wobei die Zugriffsinformation gültig ist, wenn der Betriebsmodus eines vorgegebenen Betriebsmodus ist, die Zugriffsinformation steuert ein Verfahren zum Bestimmen einer zweiten Mehrzahl von Speicherzellen- Stellen, auf welchem im Speicherblock (1300) zugegriffen werden soll, basierend auf der zweiten Adresse (LSA) aus einer ersten Mehrzahl von Speicherzellen-Stellen, welche ausgewählt wurden basierend auf der ersten Adresse (MSA) in dem Speicherblock (1300), die Zugriffsinformations-Eingabevorrichtung (1338, 1340) stellt die Zugriffsinformation als eine Ausgabe in Reaktion auf eine dritte Flanke des externen Taktsignals (RCLK) zur Verfügung;
eine Zugriffsvorrichtung (1330, 1336, 1354, 1360); und
eine Steuervorrichtung (1366);
**dadurch gekennzeichnet, dass**
die Zugriffsvorrichtung (1330, 1336, 1354, 1360) zum Zugreifen auf die zweite Mehrzahl der Speicherzellen; in den Speicherblock (1.300) ist, entsprechend der ersten Adresse (MSA) und der zweiten Adresse (LSA), zur Verfügung gestellt durch die Adresseneingabevorrichtung (1320) und die Zugriffsinformation, welche zur Verfügung gestellt wurde durch die Zugriffsinformations-Eingabevorrichtung (1338, 1340);
die Steuervorrichtung (1366) ist zum Empfangen der Steuereingabe, welche den Betriebsmodus definiert, über den zweiten Bus (140), und zum Steuern der Betriebsarten der Adresseneingabevorrichtung (1320), der Zugriffsinformations-Eingabevorrichtung (1338, 1340) und der Zugriffsvorrichtung (1330, 1336, 1354, 1360) in Reaktion auf die Steuereingabe bei einer Flanke des externen Taktsignals (RCLK),
wobei die erste Flanke des externen Taktsignals (RCLK) von der zweiten Flanke des externen Taktsignals (RCLK) verschieden ist.

2. Speicher nach Anspruch 1, wobei die Zugriffsinformations-Eingabevorrichtung (1338, 1340) die Zugriffsinformation in einer vorgegebenen Kombination der Steuereingabe empfängt, welche den Betriebsmodus definiert.

3. Speicher nach Anspruch 1 oder 2, wobei die Zugriffsvorrichtung (1330, 1336, 1354, 1360) aufweist:
eine Schreibvorrichtung zum Schreiben einer Information in den Speicherblock (1300) bei der zweiten Mehrzahl der Speicherzellen-Stellen entsprechend der ersten Adresse (MSA) der zweiten Adresse (LSA) und der Zugriffsinformation in Reaktion auf eine Viertelflanke des externen Taktsignals (RCLK).

4. Speicher nach Anspruch 3, wobei die Steuervorrichtung (1366) ein erstes Freigabesignal und ein zweites Freigabesignal an die Adresseneingabevorrichtung (1320) liefert in Reaktion auf die Steuereingabe bei einer Flanke des externen Taktsignals (RCLK), ein Zugriffsinformationsfreigabesignal an die Zugriffsinformafionseingabevorrichtung (1338, 1340) liefert in Reaktion auf die Steuereingabe bei einer Flanke des externen Taktsignals (RCLK), und ein Schreibfreigabesignal an die Schreibvorrichtung liefertin Reaktion auf die Steuereingabe bei einer Flanke des externen Taktsignals (RCLK), wobei jedes, das erste Freigabesignal, das zweite Freigabesignal, das Zugriffsinformations-Freigabesignal und das Schreibfreigabesignal synchron sind zu einer Flanke des externen Taktsignals (RCLK), und
wobei die Adresseingabevorrichtung (1320) die erste Adresse (MSA) zur Verfügung stellt in Reaktion auf das erste Freigabesignal, die Adresseneingabevorrichtung (1320), die zweite Adresse (LSA) in Reaktion auf das zweite Freigabesignal, die Zugriffsinformations-Eingabevorrichtung (1338, 1340), die Zugriffsinformation in Reaktion auf das Zugriffsinformations-Freigabesignal zur Verfügung stellt, und die Schreibvorrichtung, die Information in Reaktion auf das Schreibfreigabesignal schreibt.

5. Speicher nach Anspruch 4, wobei jedes, das erste Freigabesignal, das zweite Freigabesignal, das Zugriffsinformations-Freigabesignal und das Schreib-Freigabesignal in einem ersten Zustand oder einem zweiten Zustand ist.

6. Speicher nach Anspruch 5, wobei
die Steuervorrichtung (1366) aufweist:
eine Vorrichtung zum Bestimmen eines nächsten Zustands in Reaktion auf einen aktuellen Zustand und der Steuereingabe einer Flanke des externen Taktsignals (RCLK) und
eine Vorrichtung zum Erzeugen des ersten Freigabesignals, des zweiten Freigabesignals, des Zugriffsinformations-Freigabesignals und des Schreibfreigabesignals basierend auf dem nächsten Zustand.

7. Speicher nach einem der Ansprüche 1 bis 6, weiter aufweisend:
einen seriellen Port bzw. Anschluss (1306) aufweisend:
eine Vorrichtung zum Empfangen eines seriellen Port-Taktsignals zum Steuern des Zeitablaufs des seriellen Ports;
eine serielle Ausgabevorrichtung; und
eine Übertragungsvorrichtung zum Übertragen einer seriellen Information, welche in dem Speicherblock (1300) zu der seriellen Ausgabevorrichtung in Reaktion auf eine vierte Flanke des externen Taktsignals (RCLK);
wobei die serielle Ausgabevorrichtung sequenziell Teile der seriellen Information ausgibt in Reaktion auf jeweilige Flanken des seriellen Port-Taktsignals.

8. Speicher nach Anspruch 7,
wobei die Steuervorrichtung (1366) ein erstes Freigabesignal und ein zweites Freigabesignal der Adresseneingabevorrichtung (1320) zur Verfügung stellt in Reaktion auf die Steuereingabe bei einer Flanke des externen Taktsignals (RCLK), und ein Übertragungsfreigabesignal der Übertragungsvorrichtung zur Verfügung stellt in Reaktion auf die Steuereingabe bei einer Flanke des externen Taktsignals (RCLK), wobei jedes, das erste Freigabesignal, das zweite Freigabesignal und das Übertragungsfreigabesignal synchron sind zu einer Flanke des externen Taktsignals (RCLK), und
wobei die Adresseneingabevorrichtung (1320) die erste Adresse (MSA) in Reaktion auf das erste Freigabesignal zur Verfügung stellt, die Adresseneingabevorrichtung (1320) die zweite Adresse (LSA) in Reaktion auf das zweite Freigabesignal zur Verfügung stellt, und die Übertragungsvorrichtung, die serielle Informationen in Reaktion auf das Übertragungsfreigabesignal überträgt.

9. Speicher nach Anspruch 8, wobei jedes, das erste Freigabesignal, das zweite Freigabesignal und das Übertragungsfreigabesignal in einem ersten Zustand oder einem zweiten Zustand ist.

10. Speicher nach Anspruch 8 oder 9, wobei
die Steuervorrichtung (1366) aufweist:
eine Vorrichtung zum Bestimmen eines nächsten Zustands in Reaktion auf einen aktuellen Zustand und der Steuereingabe bei einer Flanke des externen Taktsignals (RCLK); und
eine Vorrichtung zum Erzeugen des ersten Freigabesignals und des Übertragungs-Freigabesignals basierend auf dem nächsten Zustand.

11. System in einer integrierten Schaltung mit synchronem Speicher, welche mit einem ersten Bus (90, 100) verbunden ist zum Spezifizieren einer Stelle in dem Speicher und zum Eingeben/Ausgeben von Daten und einem zweiten Bus (140) zum Eingaben einer Steuereingabe, welche einem Betriebsmodus des Speichers definiert, umfasst der Speicher einen Speicherblock (1300) mit einer Mehrzahl von Speicherzellen zum Speicher einer Information; eine Adresseneingabevorrichtung (1320) zum Empfang einer ersten Adresse (MSA) und einer zweiten Adresse (LSA); eine Zugriffsinformations-Eingabevorrichtung (1338, 1340) zum Empfangen einer Zugriffsinformation, welche gültig ist, wenn der Betriebsmodus ein vorgegebener Betriebsmodus ist, die Zugriffsinformation steuert ein Verfahren zum Bestimmen einer zweiten Mehrzahl von Speicherzellen-Stellen, auf welche zugegriffen werden soll in dem Speicherblock (1300) basierend auf der zweiten Adresse (LSA) aus einer ersten Mehrzahl von Speicherzellen-Stellen, ausgewählt basierend auf der ersten Adresse MSA in dem Speicherblock (1300); und einen Eingang (1366) zum Empfangen eines externen Taktsignals (RCLK), ein Verfahren zum Zugreifen auf den Speicher weist die Schritte auf:
a) Empfangen der ersten Adresse (MSA) über den ersten Bus (90, 100) und Liefern der ersten Adresse (MSA) als eine Ausgabe der Adressen-Eingabevorrichtung (1320) in Reaktion auf eine erste Flanke des externen Taktsignals (RCLK);
b) Empfangen der zweiten Adresse (LSA) über den ersten Bus (90, 100) und liefern der ersten Adresse (LSA) als eine Ausgabe der Adressen-Eingabevorrichtung (1320) in Reaktion auf eine zweite Flanke des externen Taktsignals (RCLK), wobei die erste Flanke des externen Taktsignals (RCLK) von der zweiten Flanke des externen Taktsignals (RCLK) verschieden ist;
c) Empfangen der Zugriffsinformation über den ersten Bus (90, 100) und Liefern der Zugriffsinformation als eine Ausgabe der Zugriffsinformations-Eingabevorrichtung (1338, 1340) in Reaktion auf eine dritte Flanke des externen Taktsignals (RCLK);
d) Zugreifen auf die zweite Mehrzahl der Speicherzellen-Stellen in dem Speicherblock (1300) entsprechend der ersten Adresse (MSA), der zweiten Adresse (LSA) und der Zugriffsinformation.

12. Verfahren nach Anspruch 11, weiter aufweisend den Schritte der Wiederholung der Schritte von (b) und c)).

13. System mit einem Speicher, einer Schaltung zum Zugreifen auf den Speicher, einem ersten Bus (90, 100), welcher die Schaltung mit dem Speicher verbindet zum Spezifizieren einer Stelle in dem Speicher und zum Übertragen einer Steuereingabe, welche einen Betriebsmodus des Speichers definiert,
die Schaltung weist eine Vorrichtung auf zum Liefern einer ersten Adresse (MSA) und einer zweiten Adresse (LSA), den ersten Bus (90,100), eine Vorrichtung zum Liefern der Steuereingabe, welche dem Betriebsmodus des Speichers definiert auf den zweiten Bus (140), und eine Vorrichtung zum Liefern einer Zugriffsinformation auf den ersten Bus (90, 100), die Zugriffsinformation ist gültig, wenn der Betriebsmodus ein vorgegebener Betriebsmodus ist, die Zugriffsinforrnation steuert ein Verfahren zum Bestimmen einer zweiten Mehrzahl von Speicherzellen-Stellen, auf welche zugegriffen werden soll in dem Speicher, basierend auf der zweiten Adresse (LSA) aus einer Mehrzahl von Speicherzellen-Stellen, ausgewählt basierend auf der ersten Adresse (MSA) in dem Speicher, die erste Adresse (MSA) ist auf dem ersten Bus (90, 100) gültig bei einer ersten Flanke eines Taktsignals (RCLK) und die zweite Adresse (LSA) ist auf dem ersten Bus (90, 100) gültig, bei einer zweiten Flanke des Taktsignals (RCLK), die Zugriffsinformation ist auf dem ersten Bus (90, 100) gültig bei einer dritten Flanke des Taktsignals (RCLK), und die Steuereingabe ist gültig auf dem zweiten Bus (140) bei einer Flanke des Taktsignals (RCLK); und
der Speicher ist eine synchrone integrierte Halbleiter-Speicherschaltung und umfasst:
einen Speicherblock (1300) umfassend eine Mehrzahl von Speicherzellen zum Speichern einer Information;
einen Eingang (1366) zum Empfangen des Taktsignals (RCLK);
eine Adressen-Eingabevorrichtung (1320) zum Empfangen einer ersten Adresse MSA und der zweiten Adresse (LSA) über den ersten Bus (90, 100), wobei die Adresseneingabevorrichtung (1320) die erste Adresse (MSA) als eine Ausgabe in Reaktion auf die erste Flanke des Taktsignals (RCLK) zur Verfügung stellt, die Adresseneingabevorrichtung (1320) stellt die zweite Adresse (LSA) als eine Ausgabereaktion auf die zweite Flanke des Taktsignals (RCLK) zur Verfügung;
eine Zugriffsinformations-Informations-Eingabevorrichtung (1338, 1340) zum Empfangen der Zugriffsinformation über den ersten Bus (90, 100) wobei die Zugriffsinformations-Eingabevorrichtung die Zugriffsinformation als eine Ausgabe in Reaktion auf die dritte Flanke des Taktsignals (RCLK);
eine Zugriffsvorrichtung (1330, 1336, 1354, 1360) und eine Steuervorrichtung (1366),
**dadurch gekennzeichnet, dass**
die Zugriffvorrichtung (1330, 1336, 1354, 1360) zum Zugreifen auf die zweite Mehrzahl von Speicherzellen-Stellen in dem Speicherblock (1300) ist, entsprechend der ersten Adresse (MSA) und der zweiten Adresse (LSA), zur Verfügung gestellt durch die Adresseneingabevorrichtung (1320) und die Zugriffsinformation, welche zur Verfügung gestellt wurde durch die Zugriffsinformations-Eingabevorrichtung (1338, 1340); und
die Steuervorrichtung (1366) ist zum Empfangen der Steuereingabe über den zweiten Bus (140), und für die Steuervorgänge der Adressen (1320), Steuervorgänge der Adresseneingabevorrichtung (1320), wobei die Zugriffsinformations-Eingabevorrichtung (1338, 1340) und die Zugriffsvorrichtung (1330, 1336, 1354, 1360) in Reaktion auf die Steuereingabe bei einer Flanke des Taktsignals (RCLK), wobei die erste Flanke des Taktsignals (RCLK) von der zweiten Flanke des Taktsignals (RCLK) verschieden ist.

14. System nach Anspruch 13, wobei die Zugriffvorrichtung (1330, 1336, 1354, 1360) aufweist:
eine Schreibvorrichtung zum Schreiben einer Information in den Speicherblock (1300) bei der zweiten Mehrzahl der Speicherzellen-Stellen entsprechend der ersten Adresse. (MSA), der zweiten Adresse (LSA) und der Zugriffsinformation in Reaktion auf eine vierte Flanke des Taktsignals (RCLK).

15. System nach Anspruch 14,
wobei die Steuervorrichtung (1366) ein erstes Freigabesignal und ein zweites Freigabesignal der Adresseneingabevorrichtung (1320) zur Verfügung stellt in Reaktion auf die Steuereingabe einer Flanke des Taktsignals (RCLK) ein Zugriffsinformations-Freigabesignal der Zugriffsinformations-Eingabevorrichtung (1338, 1340) zur Verfügung stellt in Reaktion auf die Steuereingabe bei einer Flanke des Taktsignals (RCLK), und ein Schreibfreigabesignal der Schreibvorrichtung zur Verfügung stellt in Reaktion auf die Steuereingabe bei einer Flanke des Taktsignals (RCLK), wobei jedes, das erste Freigabesignal, das zweite Freigabesignal, das Zugriffsinformations-Freigabesignal und das Schreibfreigabesignal synchron sind zu einer Flanke des Taktsignals (RCLK) und wobei die Adressen-Eingabevorrichtung (1320) die erste Adresse (MSA) zur Verfügung stellt in Reaktion auf das erste Freigabesignal, die Adresseneingabevorrichtung (1320) stellt die zweite Adresse LSA zur Verfügung in Reaktion auf das zweite Freigabesignal, die Zugriffsinformations-Eingabevorrichtung (1338, 1340) stellt die Zugriffsinformation zur Verfügung in Reaktion auf das Zugriffsinformations-Freigabesignal, und die Schreibvorrichtung schreibt die Information in Reaktion auf das Schreibfreigabesignal.

16. Signal nach einem der Ansprüche 13 bis 15,
wobei der erste Bus (90, 100) einen Adressbus (100) aufweist zum Übertragen bzw. Transportieren der ersten Adresse (MSA) und der zweiten Adresse (LSA) und einen Datenbus (90) zum Übertragen bzw. Transportieren der Daten.

## Revendications

1. Circuit intégré de mémoire synchrone à semi-conducteur connecté à un premier bus (90, 100), destiné à préciser un emplacement dans un bloc de mémoire (1300) et à entrer et délivrer des données, et à un deuxième bus (140) destiné à entrer une entrée de commande définissant un mode de fonctionnement de ladite mémoire synchrone à semi-conducteur, comprenant :
un bloc de mémoire (1300) comprenant une pluralité de cellules de mémoire destinées à la mémorisation d'informations ;
une entrée (1366) destinée à recevoir un signal d'horloge externe (RCLK) ;
un moyen d'entrée d'adresse (1320) destiné à recevoir une première adresse (MSA) et une deuxième adresse (LSA) par l'intermédiaire dudit premier bus (90, 100), ledit moyen d'entrée d'adresse (1320) délivrant ladite première adresse (MSA) comme sortie en réponse à un premier front dudit signal d'horloge externe (RCLK), ledit moyen d'entrée d'adresse (1320) délivrant ladite deuxième adresse (LSA) comme sortie en réponse à un deuxième front dudit signal d'horloge externe (RCLK) ;
des moyens d'entrée d'informations d'accès (1338, 1340) destinés à recevoir les informations d'accès par l'intermédiaire dudit premier bus (90), lesdites informations d'accès étant valides quand ledit mode de fonctionnement est un mode de fonctionnement prédéterminé, lesdites informations d'accès commandant un procédé destiné à déterminer une deuxième pluralité d'emplacements de cellules de mémoire auxquels accéder dans ledit bloc de mémoire (1300) en se basant sur ladite deuxième adresse (LSA) parmi une première pluralité d'emplacements de cellules de mémoire sélectionnés en se basant sur ladite première adresse (MSA) dans ledit bloc de mémoire (1300), lesdits moyens d'information d'accès (1338, 1340) délivrant lesdites informations d'accès comme sortie en réponse à un troisième front dudit signal d'horloge externe (RCLK) ;
des moyens d'accès (1330, 1336, 1354, 1360) ; et
un moyen de commande (1366) ;
**caractérisée en ce que**
les moyens d'accès (1330, 1336, 1354, 1360) sont destinés à accéder à ladite deuxième pluralité d'emplacements de cellules de mémoire dans ledit bloc de mémoire (1300) correspondant à ladite première adresse (MSA) et à ladite deuxième adresse (LSA) délivrées par ledit moyen d'entrée d'adresses (1320) et auxdites information d'accès délivrées par lesdits moyens d'entrée d'informations d'accès (1338, 1340) ;
**en ce que** le moyen de commande (1336) est destiné à recevoir ladite entrée de commande définissant ledit mode de fonctionnement par l'intermédiaire dudit deuxième bus (140), et à commander le fonctionnement dudit moyen d'entrée d'adresse (1320), desdits moyens d'entrée d'informations d'accès (1338, 1340), et desdits moyens d'accès (1330, 1336, 1354, 1360) en réponse à ladite entrée de commande sur un front dudit signal d'horloge externe (RCLK),
dans lequel ledit premier front dudit signal d'horloge externe (RCLK) est différent dudit deuxième front dudit signal d'horloge externe (RCLK).

2. Mémoire selon la revendication 1, dans laquelle lesdits moyens d'information d'accès (1338, 1340) reçoivent lesdites informations d'accès selon une combinaison prédéterminée desdites entrées de commande définissant lesdits modes de fonctionnement.

3. Mémoire selon la revendication 1 ou 2, dans laquelle lesdits moyens d'accès (1330, 1336, 1354, 1360) comprennent
un moyen d'écriture destiné à écrire des informations à ladite pluralité d'emplacements de cellules de mémoire correspondant à ladite première adresse (MSA), à ladite deuxième adresse (LSA) et auxdites informations d'accès en réponse à un quatrième front dudit signal d'horloge externe (RCLK).

4. Mémoire selon la revendication 3,
dans laquelle ledit moyen de commande (1366) délivre un premier signal de validation et un deuxième signal de validation audit moyen d'entrée d'adresses (1320) en réponse à ladite entrée de commande sur un front dudit signal d'horloge externe (RCLK), délivre un signal de validation d'information d'accès auxdits moyens d'entrée d'information (1338, 1340) en réponse à ladite entrée de commande sur un front dudit signal d'horloge externe (RCLK), et délivre un signal de validation d'écriture audit moyen d'écriture en réponse à ladite entrée de commande sur un front dudit signal d'horloge externe (RCLK), chacun parmi ledit premier signal de validation, ledit deuxième signal de validation, ledit signal de validation des informations d'accès et ledit signal de validation d'écriture étant synchrones avec un front dudit signal d'horloge externe (RCLK), et
dans lequel ledit moyen d'entrée d'adresse (1320)-délivre ladite première adresse (MSA) en réponse audit premier signal de validation, dans lequel ledit moyen d'entrée d'adresse (1320) délivre ladite deuxième adresse (LSA) en réponse audit deuxième signal de validation, dans lequel lesdits moyens d'informations d'accès (1338, 1340) délivrent lesdites informations d'accès en réponse audit signal de validation des informations d'accès, et dans lequel ledit moyen d'écriture écrit lesdites informations en réponse audit signal de validation d'écriture.

5. Mémoire selon la revendication 4, dans laquelle chacun parmi ledit premier signal de validation, ledit deuxième signal de validation, ledit signal de validation d'information d'accès et ledit signal de validation d'écriture est soit dans un premier état, soit dans un deuxième état.

6. Mémoire selon la revendication 5, dans laquelle
ledit moyen de commande (1366) comprend :
un moyen destiné à déterminer un état suivant en réponse à un état actuel et à ladite entrée de commande sur un front dudit signal d'horloge externe (RCLK) ; et
un moyen destiné à générer ledit premier signal de validation, ledit deuxième signal de validation, ledit signal de validation d'information d'accès et ledit signal de validation d'écriture en se basant sur ledit état suivant.

7. Mémoire selon l'une des revendications 1 à 6,
comprenant en outre :
un accès série (1306) incluant :
un moyen destiné à recevoir un signal d'horloge d'accès série destiné à commander la synchronisation dudit accès série ;
un moyen de sortie série ; et
un moyen de transfert destiné à transférer les informations série mémorisées dans ledit bloc de mémoire (1300) audit moyen de sortie série en réponse à un quatrième front de signal d'horloge externe (RCLK) ;
dans laquelle ledit moyen de sortie série délivre séquentiellement des parties de sortie desdites informations série en réponse aux fronts respectifs dudit signal d'horloge d'accès série.

8. Mémoire selon la revendication 7,
dans laquelle ledit moyen de commande (1366) délivre un premier signal de validation et un deuxième signal de validation audit moyen d'entrée d'adresses (1320) en réponse à ladite entrée de commande sur un front dudit signal d'horloge externe (RCLK), et délivre un signal de validation de transfert audit moyen de transfert en réponse à ladite entrée de commande sur un front dudit signal d'horloge externe (RCLK), chacun parmi ledit premier signal de validation, ledit deuxième signal de validation et ledit signal de validation de transfert étant synchrone avec un front dudit signal d'horloge externe (RCLK), et
dans laquelle ledit moyen d'entrée d'adresses (1320) délivre ladite première adresse (MSA) en réponse audit premier signal de validation, dans laquelle ledit moyen d'entrée d'adresse (1320) délivre ladite deuxième adresse (MSA) en réponse audit deuxième signal de validation, et
dans laquelle ledit moyen de transfert transfère lesdites informations série en réponse audit signal de validation de transfert.

9. Mémoire selon la revendication 8, dans laquelle chacun parmi ledit premier signal de validation, ledit deuxième signal de validation et ledit signal de validation de transfert est soit dans un premier état, soit dans un deuxième état.

10. Mémoire selon la revendication 8 ou 9, dans laquelle
ledit moyen de commande (1366) comprend :
un moyen destiné à déterminer un état suivant en réponse à un état actuel et à ladite entrée de commande sur un front dudit signal d'horloge externe (RCLK) ; et
un moyen destiné à générer ledit premier signal de validation, ledit deuxième signal de validation, ledit signal de validation de transfert en se basant sur ledit état suivant.

11. Dans un circuit intégré de mémoire synchrone connecté à un premier bus (90, 100), destiné à préciser un emplacement dans ladite mémoire et à entrer et délivrer des données, et à un deuxième bus (140) destiné à entrer une entrée de commande définissant un mode de fonctionnement de ladite mémoire, ladite mémoire comprenant un bloc de mémoire (1300) possédant une pluralité de cellules de mémoire destinées à la mémorisation d'informations ; un moyen d'entrée d'adresses (1320) destiné à recevoir une première adresse (MSA) et une deuxième adresse (LSA); des moyens d'entrée d'information d'accès (1338, 1340) destinés à recevoir les informations qui sont valides quand ledit mode de fonctionnement est un mode de fonctionnement prédéterminé, lesdites informations d'accès commandant un procédé destiné à déterminer une deuxième pluralité d'emplacements de cellules de mémoire auxquels accéder dans ledit bloc de mémoire (1300) en se basant sur ladite deuxième adresse (LSA) parmi une première pluralité d'emplacements de cellules de mémoire sélectionnées en se basant sur ladite première adresse (MSA) dans ledit bloc de mémoire (1300) ; et une entrée (1366) destinée à recevoir un signal d'horloge externe (RCLK) ;
un procédé destiné à accéder à ladite mémoire, comprenant les étapes consistant à :
a) recevoir ladite première adresse (MSA) par l'intermédiaire dudit premier bus (90, 100) et délivrer ladite première adresse (MSA) comme sortie dudit moyen d'entrée d'adresse (1320) en réponse à un premier front dudit signal d'horloge externe (RCLK) ;
b) recevoir ladite deuxième adresse (LSA) par l'intermédiaire dudit premier bus (90, 100) et délivrer ladite deuxième adresse (LSA) comme sortie dudit moyen d'entrée d'adresse (1320) en réponse à un deuxième front dudit signal d'horloge externe (RCLK), dans lequel le premier front dudit signal d'horloge externe (RCLK) est différent dudit deuxième front dudit signal d'horloge externe (RCLK) ;
c) recevoir ladite information d'accès par l'intermédiaire dudit premier bus (90, 100) et délivrer ladite information d'accès comme sortie desdits moyens d'entrée d'information d'accès (1338, 1340) en réponse à un troisième front dudit signal d'horloge externe (RCLK) ;
d) accéder à ladite deuxième pluralité d'emplacements de cellules de mémoire dans ledit bloc de mémoire (1300) correspondant à ladite première adresse (MSA), à ladite deuxième adresse (LSA) et auxdites informations d'accès.

12. Procédé selon la revendication 11, comprenant en outre l'étape consistant à répéter les étapes b) et d).

13. Système comprenant une mémoire, un circuit destiné à accéder à ladite mémoire, un premier bus (90, 100) reliant ledit circuit à ladite mémoire dans le but de préciser un emplacement dans ladite mémoire et de transporter les données et un deuxième bus (140) destiné à relier ledit circuit à ladite mémoire dans le but de transporter ladite entrée de commande définissant le mode de fonctionnement de ladite mémoire,
ledit circuit comprenant un moyen destiné à délivrer une première adresse (MSA) et une deuxième adresse (LSA) sur ledit premier bus (90, 100), un moyen destiné à délivrer ladite entrée de commande définissant ledit mode de fonctionnement de ladite mémoire sur ledit deuxième bus (140) et un moyen destiné à délivrer les informations d'accès sur ledit premier bus (90, 100), lesdites informations d'accès étant valides quand ledit mode de fonctionnement est un mode de fonctionnement prédéterminé, lesdites informations d'accès commandant un procédé destiné à déterminer une deuxième pluralité d'emplacements de cellules de mémoire auxquels accéder dans ladite mémoire en se basant sur ladite deuxième adresse (LSA) parmi une première pluralité d'emplacements de cellules de mémoire sélectionnées en se basant sur ladite première adresse (MSA) dans ladite mémoire, ladite première adresse (MSA) étant valide sur ledit premier bus (90, 100) sur un premier front d'un signal d'horloge externe (RCLK) et ladite deuxième adresse (LSA) étant valide sur ledit premier bus (90, 100) sur un deuxième front dudit signal d'horloge externe (RCLK), lesdites informations d'accès étant valides sur ledit premier bus (90, 100) sur un troisième front dudit signal d'horloge externe (RCLK), et ladite entrée de commande étant valide sur ledit deuxième bus (140) sur un front dudit signal d'horloge externe (RCLK) ; et
ladite mémoire étant un circuit intégré de mémoire synchrone à semi-conducteur comprenant :
un bloc de mémoire (1300) comprenant une pluralité de cellules de mémoire destinées à la mémorisation d'informations
une entrée (1366) destinée à recevoir ledit signal d'horloge externe (RCLK) ;
un moyen d'entrée d'adresses (1320) destiné à recevoir ladite première adresse (MSA) et ladite deuxième adresse (LSA) par l'intermédiaire dudit premier bus (90, 100), ledit moyen d'entrée d'adresse (1320) délivrant ladite première adresse (MSA) comme sortie en réponse audit premier front dudit signal d'horloge externe (RCLK), ledit moyen d'entrée d'adresse (1320) délivrant ladite deuxième adresse (LSA) comme sortie en réponse audit deuxième front dudit signal d'horloge externe (RCLK) ;
des moyens d'entrée d'information d'accès (1338, 1340) destinés à recevoir lesdites informations d'accès. par l'intermédiaire dudit premier bus (90, 100), ledit moyen d'entrée d'informations d'accès délivrant lesdites informations d'accès comme réponse audit troisième front dudit signal d'horloge externe (RCLK) ;
des moyens d'accès (1330, 1336, 1354, 1360) ; et
un moyen de commande (1366) ;
**caractérisé en ce que**
les moyens d'accès (1330, 1336, 1354, 1360) sont destinés à accéder à ladite deuxième pluralité d'emplacements de cellules de mémoire dans ledit bloc de mémoire (1300) correspondant à ladite première adresse (MSA) et à ladite deuxième adresse (LSA) délivrées par ledit moyen d'entrée d'adresses (1320) et à ladite information d'accès délivrée par lesdits moyens d'entrée d'informations d'accès (1338, 1340) ;
**en ce que** le moyen de commande (1336) est destiné à recevoir ladite entrée de commande par l'intermédiaire dudit deuxième bus (140), et à commander le fonctionnement dudit moyen d'entrée d'adresses (1320), desdits moyens d'entrée d'information d'accès (1338, 1340), et desdits moyens d'accès (1330, 1336, 1354, 1360) en réponse à ladite entrée de commande sur un front dudit signal d'horloge externe (RCLK), le premier front dudit signal d'horloge externe (RCLK) étant différent dudit deuxième front dudit signal d'horloge externe (RCLK).

14. Système selon la revendication 13, dans lequel lesdits moyens d'accès (1330, 1336, 1354, 1360) comprennent :
un moyen d'écriture destiné à écrire les informations dans ledit bloc de mémoire (1300) à la deuxième pluralité d'emplacements de cellules de mémoire correspondant à ladite première adresse (MSA), à ladite deuxième adresse (LSA) et auxdites informations d'accès en réponse à un quatrième front dudit signal d'horloge externe (RCLK).

15. Système selon la revendication 14,
dans lequel ledit moyen de commande (1366) délivre un premier signal de validation et un deuxième signal de validation audit moyen d'entrée d'adresses (1320) en réponse à ladite entrée de commande sur un front dudit signal d'horloge externe (RCLK), délivre un signal de validation d'information d'accès auxdits moyens de commande d'information d'accès (1338, 1340) en réponse à ladite entrée de commande sur un front dudit signal d'horloge externe (RCLK), et délivre un signal de validation d'écriture audit moyen d'écriture en réponse à ladite entrée de commande sur un front dudit signal d'horloge externe (RCLK), chacun parmi ledit premier signal de validation, ledit deuxième signal de validation, ledit signal de validation d'information d'accès et ledit signal de validation d'écriture étant synchrone avec un front dudit signal d'horloge externe (RCLK), et ledit moyen d'entrée d'adresses (1320) délivrant ladite première adresse (MSA) en réponse audit premier signal de validation, ledit moyen d'entrée d'adresses (1320) délivrant ladite deuxième adresse (LSA) en réponse audit deuxième signal de validation, lesdits moyens d'entrée d'information d'accès (1338, 1340) délivrant lesdites informations d'accès en réponse audit signal de validation des informations d'accès, et ledit moyen d'écriture écrivant lesdites informations en réponse audit signal de validation d'écriture.

16. Système selon l'une des revendications 13 à 15,
dans lequel ledit premier bus (90, 100) comprend un bus d'adressage (100) destiné à transporter ladite première adresse (MSA) et ladite deuxième adresse (LSA) et un bus de données destiné à transporter lesdites données.
